# EUROPEAN PATENT APPLICATION

(11) **EP 4 410 912 A1**
(43) Date of publication of application: **07.08.2024**
(21) Application number: 22875420.6
(22) Date of filing: 30.03.2022
(51) Int. Cl.: C09J 7/38, C09J 7/20, H01L 21/301, H01L 21/304, C09J 133/04

(54) **PRESSURE-SENSITIVE ADHESIVE SHEET FOR TEMPORARILY FIXING ELECTRONIC COMPONENT AND METHOD FOR TREATING ELECTRONIC COMPONENT**

(30) Priority: 29.09.2021 JP 2021159317
(71) Applicant: Nitto Denko Corporation, Ibaraki-shi, Osaka 567-8680 (JP)
(72) Inventor: UENO, Shusaku, Ibaraki-shi, Osaka 567-8680 (JP); KATO, Kazumichi, Ibaraki-shi, Osaka 567-8680 (JP); HIRAYAMA, Takamasa, Ibaraki-shi, Osaka 567-8680 (JP)
(74) Representative: Müller-Boré & Partner Patentanwälte PartG mbB
(86) International application number: PCT/JP2022/015755
(87) International publication number: WO 2023/053537

(57) **Abstract**

Provided is a pressure-sensitive adhesive sheet to be subjected to temporary fixing of an electronic part to a support, the pressure-sensitive adhesive sheet being capable of exhibiting peelability from the support through irradiation with laser light, and reducing a residue on the support after its peeling. A pressure-sensitive adhesive sheet for temporarily fixing an electronic part of the present invention includes: a photothermal conversion layer; and a thermal decomposition layer directly arranged on the photothermal conversion layer. A 5% weight loss temperature of the thermal decomposition layer after UV irradiation is lower than a 5% weight loss temperature of the photothermal conversion layer after UV irradiation.

## Description

### Technical Field

The present invention relates to a pressure-sensitive adhesive sheet for temporarily fixing an electronic part and a method of treating an electronic part.

### Background Art

There has been a growing requirement for downsizing and thinning of an electronic part year by year. For example, for improvements in characteristics of a semiconductor device, there has been a growing trend toward thinning of a semiconductor wafer mainly in fields such as a power device. In an application in which a thin and fragile semiconductor substrate (e.g., a silicon wafer) is processed and handled, a method of reducing a risk of cracking in processing and handling processes by temporarily fixing the substrate to an optically transparent hard substrate (support) such as glass with a liquid adhesive has been widely used (e.g., Patent Literature 1). In such temporary fixing method, a photothermal conversion layer and a joining layer are formed on an optically transparent substrate through a plurality of times of film formation steps, and it is required that: a workpiece be firmly fixed at the time of processing; and such a laser debonding property as described below be exhibited at the time of peeling: the workpiece and the optically transparent substrate can be easily separated from each other by irradiation with laser light having a predetermined wavelength and thermal decomposition of the photothermal conversion layer through absorption of the light and conversion of the light into heat. However, there has been a problem in that seizure of a decomposition product occurs at the time of the thermal decomposition of the photothermal conversion layer, and hence a residue that is difficult to wash off is generated on the hard substrate (support) that is brought into contact therewith. Accordingly, the above-mentioned problem has been a cause of increasing the manufacturing cost of the semiconductor device because the hard substrate (support) is made disposable, or a large washing load is involved even when the hard substrate is recovered and reused.

### Citation List

### Patent Literature

[PTL 1] JP 4565804 B2

### Summary of Invention

### Technical Problem

The present invention has been made to solve the above-mentioned problem, and an object of the present invention is to provide a pressure-sensitive adhesive sheet to be subjected to temporary fixing of an electronic part to a support, the pressure-sensitive adhesive sheet being capable of exhibiting peelability from the support through irradiation with laser light, and reducing a residue on the support after its peeling.

### Solution to Problem

According to one aspect of the present invention, there is provided a pressure-sensitive adhesive sheet for temporarily fixing an electronic part, including: a photothermal conversion layer; and a thermal decomposition layer directly arranged on the photothermal conversion layer. A 5% weight loss temperature of the thermal decomposition layer after UV irradiation is lower than a 5% weight loss temperature of the photothermal conversion layer after UV irradiation.

In one embodiment, the 5% weight loss temperature of the photothermal conversion layer after UV irradiation is from 300°C to 600°C.

In one embodiment, the 5% weight loss temperature of the thermal decomposition layer after UV irradiation is from 250°C to 400°C.

In one embodiment, the photothermal conversion layer has a transmittance for light having a wavelength of 355 nm of 50% or less.

In one embodiment, the photothermal conversion layer is a resin film formed of a polyimide-based resin.

In one embodiment, the thermal decomposition layer has a transmittance for light having a wavelength of 355 nm of 80% or more.

In one embodiment, the photothermal conversion layer has a transmittance for light having a wavelength of 1,032 nm of 50% or less.

In one embodiment, the photothermal conversion layer is a colored film.

In one embodiment, the thermal decomposition layer has a transmittance for light having a wavelength of 1,032 nm of 80% or more.

In one embodiment, the thermal decomposition layer contains an active energy ray-curable pressure-sensitive adhesive.

In one embodiment, the thermal decomposition layer has a strain at break after UV irradiation of 50% or more.

In one embodiment, the photothermal conversion layer has a tensile modulus of elasticity at 200°C after UV irradiation of from 5 MPa to 2 GPa.

In one embodiment, the pressure-sensitive adhesive sheet for temporarily fixing an electronic part further includes a pressure-sensitive adhesive layer. The pressure-sensitive adhesive layer, the photothermal conversion layer, and the thermal decomposition layer are laminated in the stated order.

According to another aspect of the present invention, there is provided a method of treating an electronic part. This treatment method includes subjecting an electronic part to predetermined treatment after arranging the electronic part on the above-mentioned pressure-sensitive adhesive sheet.

In one embodiment, the treatment is grinding processing, dicing processing, die bonding, wire bonding, etching, vapor deposition, molding, rewiring formation, through-hole formation, or protection of a device surface.

### Advantageous Effects of Invention

According to the present invention, the pressure-sensitive adhesive sheet to be subjected to temporary fixing of an electronic part to a support, the pressure-sensitive adhesive sheet being capable of exhibiting peelability from the support through irradiation with laser light, and reducing a residue on the support after its peeling, can be provided.

### Brief Description of Drawings

FIG. **1** is a schematic sectional view of a pressure-sensitive adhesive sheet according to one embodiment of the present invention.
FIGS. **2** are each a view for illustrating a method of using the pressure-sensitive adhesive sheet of one embodiment of the present invention.

### Description of Embodiments

### A. Outline of Pressure-sensitive Adhesive Sheet for temporarily fixing Electronic Part

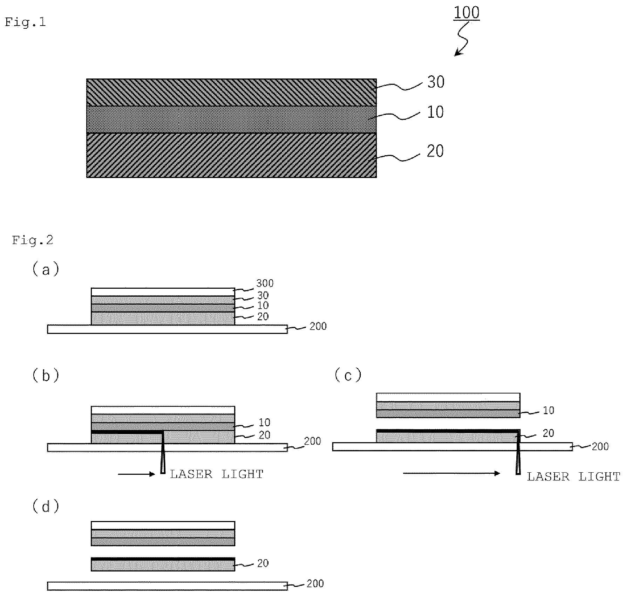

FIG. **1** is a schematic sectional view of a pressure-sensitive adhesive sheet for temporarily fixing an electronic part according to one embodiment of the present invention. A pressure-sensitive adhesive sheet **100** for temporarily fixing an electronic part includes a photothermal conversion layer **10** and a thermal decomposition layer **20** directly arranged on the photothermal conversion layer. The photothermal conversion layer is a layer that absorbs light having a predetermined wavelength and converts the light into heat. The temperature of the thermal decomposition layer is increased by the heat generation of the photothermal conversion layer, and as a result, the thermal decomposition layer is decomposed. As a result, the pressure-sensitive adhesive sheet for temporarily fixing an electronic part (hereinafter also simply referred to as "pressure-sensitive adhesive sheet") shows peelability. In one embodiment, the heat generation of the photothermal conversion layer is caused by laser light irradiation. The term "thermal decomposition" as used herein means that a weight reduction of 5% or more may occur through heating to 250°C or more. In addition, the term "directly arranged" means a state in which any other layer is free from being arranged between the photothermal conversion layer and the thermal decomposition layer, and those layers are brought into contact with each other. Meanwhile, the pressure-sensitive adhesive sheet may further include any other layer as long as the effect of the present invention is obtained. For example, as illustrated in FIG. **1****,** any appropriate pressure-sensitive adhesive layer **30** may be arranged on the side of the photothermal conversion layer **10** opposite to the thermal decomposition layer **20.** That is, in one embodiment, the pressure-sensitive adhesive sheet **100** in which the pressure-sensitive adhesive layer **30,** the photothermal conversion layer **10,** and the thermal decomposition layer **20** are laminated in the stated order may be provided.

In the pressure-sensitive adhesive sheet, a 5% weight loss temperature of the thermal decomposition layer after UV irradiation is lower than a 5% weight loss temperature of the photothermal conversion layer after UV irradiation. The term "5% weight loss temperature after UV irradiation" refers to a 5% weight loss temperature measured after the pressure-sensitive adhesive sheet is irradiated with light having a wavelength of 365 nm at an integrated light quantity of 1,380 mJ/cm². The 5% weight loss temperature means a temperature at the time point when the weight of a sample to be evaluated at the time of an increase in temperature of the sample reduces by 5 wt% as compared to the weight thereof before the temperature increase. The 5% weight loss temperature is measured with a differential thermal analyzer under the measurement conditions of a rate of temperature increase of 10°C/min and a flow rate of 25 ml/min under an air atmosphere.

In one embodiment, the pressure-sensitive adhesive sheet is used by: bonding the thermal decomposition layer serving as a pressure-sensitive adhesive layer to a support; and arranging an electronic part (e.g., a semiconductor part such as a semiconductor wafer) on a photothermal conversion layer side thereof. In the present invention, the pressure-sensitive adhesive sheet includes the photothermal conversion layer and the thermal decomposition layer, that is, a layer that absorbs laser light to generate heat (photothermal conversion layer) and a layer that is thermally decomposed more easily than the photothermal conversion layer and that contributes to peeling (thermal decomposition layer) are different layers. Thus, separation of the electronic part from the support can be easily performed, and occurrence of a residue on the support can be prevented. More specifically, the pressure-sensitive adhesive sheet of the present invention may show such behavior as shown in FIGS. **2** and as described below, and can provide such effects as described above.
(1) The pressure-sensitive adhesive sheet **100** is arranged on a support **200** so that a thermal decomposition layer side thereof is on a support **200** side, and an electronic part **300** serving as a workpiece is further arranged on the side of the pressure-sensitive adhesive sheet **100** opposite to the support **200** (FIG. **2(a)**). The thermal decomposition layer preferably include an active energy ray-curable pressure-sensitive adhesive, and the entirety of the thermal decomposition layer is irradiated with an active energy ray such as UV light before the irradiation of the pressure-sensitive adhesive sheet **100** with laser light. Through the active energy ray irradiation, peelability (in particular, peelability at the time of the separation of the electronic part from the support) of the thermal decomposition layer can be controlled.
(2) When the pressure-sensitive adhesive sheet **100** arranged on the support **200** is irradiated with laser light, the photothermal conversion layer **10** generates heat, and the generated heat propagates to the thermal decomposition layer **20,** which is adjacent thereto, and hence the thermal decomposition layer **20** is decomposed at an interface with the photothermal conversion layer **10** (FIG. **2(b)**). In one embodiment, the decomposition of the thermal decomposition layer locally occurs.
(3) As a result, the thermal decomposition layer **20** changes its form at the interface with the photothermal conversion layer **10** to lose its pressure-sensitive adhesive property, and hence peeling of the photothermal conversion layer **10** from the support **200** is enabled (FIG. **2(c)**). As a result, separation of the electronic part from the support can be performed.
(4) Next, the thermal decomposition layer **20** on the support **200** is peeled. Thus, a clean support **200** suppressed in a residue can be recovered (FIG. **2(d)**).

In the present invention, the pressure-sensitive adhesive sheet includes the photothermal conversion layer and the thermal decomposition layer. Thus, peeling of the pressure-sensitive adhesive sheet by the above-mentioned operation is enabled, the electronic part can be separated from the support with reduced damage to the electronic part, and the thermal decomposition layer on a support side can be peeled easily and while a residue is prevented. In addition, the 5% weight loss temperature of the thermal decomposition layer after UV irradiation is set to be lower than 5% weight loss temperature of the photothermal conversion layer after UV irradiation. Thus, peeling at an interface between the thermal decomposition layer and the photothermal conversion layer is promoted, and hence the above-mentioned effect becomes significant.

A support formed of any appropriate material may be used as the support. For example, a support formed of: a glass, such as borosilicate glass or quartz glass; sapphire; or an acrylic resin or any other resin, such as polymethyl methacrylate (PMMA) or polycarbonate (PC), is used. In one embodiment, a support free of an organic layer on its surface is used. The arithmetic surface roughness Ra of the support is, for example, from 0.3 nm to 100 nm, more preferably from 0.4 nm to 50 nm. The arithmetic surface roughness Ra may be measured in conformity with JIS B 0601. In general, the surface roughness of the support is preferably as small as possible from the viewpoint of prevention of a residue. In addition, the support is preferably optically transparent in the range of from UV light to an infrared ray. In particular, the support is preferably optically transparent to laser light having any appropriate wavelength to be selected. The transmittance of the support at a wavelength of laser light is, for example, 50% or more, more preferably 60% or more. The water contact angle of a support surface is, for example, from 0° to 150°, more preferably from 3° to 120°. According to the present invention, even when a support that has heretofore been difficult to achieve satisfactory peeling (e.g., causing a residue or having a poor pickup property) is used, there is an advantage in that preferred peeling is enabled, that is, the range of selection of the support is enlarged.

An initial pressure-sensitive adhesive strength at 23°C when the thermal decomposition layer is bonded to a glass plate is preferably from 0.3 N/20 mm to 20 N/20 mm, more preferably from 0.5 N/20 mm to 15 N/20 mm. When the initial pressure-sensitive adhesive strength falls within such ranges, a pressure-sensitive adhesive sheet suitable for an application of temporary fixing without causing a positional shift or the like on the support can be obtained. A pressure-sensitive adhesive strength is measured in conformity with JIS Z 0237:2000. Specifically, the measurement is performed by: reciprocating a 2-kilogram roller once to bond the thermal decomposition layer to the glass plate (arithmetic average surface roughness Ra: 1018 nm); and then peeling the pressure-sensitive adhesive sheet under the conditions of a peel angle of 180° and a peel rate (tensile rate) of 300 mm/min. Although the pressure-sensitive adhesive strength of the thermal decomposition layer may be changed by active energy ray irradiation and laser light irradiation, the term "initial pressure-sensitive adhesive strength" as used herein means a pressure-sensitive adhesive strength before the active energy ray irradiation and the laser light irradiation.

In one embodiment, a pressure-sensitive adhesive strength at 23°C after UV irradiation after the thermal decomposition layer has been bonded to the glass plate, and the resultant has been irradiated with light having a wavelength of 365 nm at an integrated light quantity of 1,380 mJ/cm² is preferably from 0.01 N/20 mm to 3 N/20 mm, more preferably from 0.05 N/20 mm to 2 N/20 mm. When the pressure-sensitive adhesive strength falls within such ranges, a pressure-sensitive adhesive sheet having excellent peelability can be obtained.

The thickness of the pressure-sensitive adhesive sheet is preferably from 10 um to 500 µm, more preferably from 20 um to 400 µm.

In one embodiment, the transmittance of the pressure-sensitive adhesive sheet for light having a wavelength of 355 nm is from 0% to 50%, more preferably from 0% to 40%, still more preferably from 0% to 35%. In addition, in another embodiment, the transmittance of the pressure-sensitive adhesive sheet for light having a wavelength of 1,032 nm is from 0% to 50%, more preferably from 0% to 40%, still more preferably from 0% to 35%. Herein, the transmittances for light of the pressure-sensitive adhesive sheet and the respective layers (to be described later) are each a transmittance measured after irradiation with light having a wavelength of 365 nm at an integrated light quantity of 1,380 mJ/cm².

### B. Photothermal Conversion Layer

The 5% weight loss temperature of the photothermal conversion layer after UV irradiation is preferably from 300°C to 600°C, more preferably from 315°C to 590°C. When the 5% weight loss temperature falls within such ranges, the effect of the invention of the present application becomes significant. Herein, it should be noted that the characteristics "after UV irradiation" may be defined, but whether the characteristics of the photothermal conversion layer are changed through UV irradiation is not specified with such definition. The photothermal conversion layer may be a layer having characteristics that are changed (e.g., cured) through UV irradiation, and may be a layer having characteristics that are not changed even by UV irradiation.

As described above, the 5% weight loss temperature of the thermal decomposition layer after UV irradiation is lower than the 5% weight loss temperature of the photothermal conversion layer after UV irradiation. A difference between the 5% weight loss temperature of the thermal decomposition layer after UV irradiation and the 5% weight loss temperature of the photothermal conversion layer after UV irradiation is preferably from 10°C to 300°C, more preferably from 50°C to 280°C. When the difference falls within such ranges, the effect of the invention of the present application becomes significant.

The thickness of the photothermal conversion layer is preferably from 5 um to 200 µm, more preferably from 10 um to 150 µm.

In one embodiment, the transmittance of the photothermal conversion layer for light having a wavelength of 355 nm is 50% or less, more preferably 40% or less, still more preferably 35% or less, most preferably 0%. When the transmittance falls within such ranges, a photothermal conversion layer that preferably absorbs UV laser light and easily generates heat can be formed.

In one embodiment, the transmittance of the photothermal conversion layer for light having a wavelength of 1,032 nm is 50% or less, more preferably 40% or less, still more preferably 35% or less, most preferably 0%. When the transmittance falls within such ranges, a photothermal conversion layer that preferably absorbs IR laser light and easily generates heat can be formed.

The tensile modulus of elasticity at 200°C of the photothermal conversion layer after UV irradiation is preferably from 5 MPa to 2 GPa, more preferably from 10 MPa to 1.8 GPa. When the tensile modulus of elasticity falls within such ranges, migration of a decomposition gas generated in the thermal decomposition layer to the side of the photothermal conversion layer opposite to the thermal decomposition layer is prevented, and hence the decomposition gas can be retained near the interface between the photothermal conversion layer and the thermal decomposition layer. Accordingly, a separation property of the electronic part from the support can be improved. For example, when the pressure-sensitive adhesive layer is arranged on the side of the photothermal conversion layer opposite to the thermal decomposition layer, an inflow of the decomposition gas to an interface between the pressure-sensitive adhesive layer and the electronic part is prevented, and the electronic part can be separated from the support under a state in which the electronic part is protected with the photothermal conversion layer. The term "tensile modulus of elasticity after UV irradiation" as used herein means a tensile modulus of elasticity measured after irradiation with light having a wavelength of 365 nm at an integrated light quantity of 1,380 mJ/cm². The tensile modulus of elasticity may be measured with a dynamic viscoelasticity-measuring apparatus. A specific measurement method is described later. Even when the photothermal conversion layer is multilayered, the tensile modulus of elasticity of the photothermal conversion layers as a whole is measured. In one embodiment, the tensile modulus of elasticity of the photothermal conversion layer at 200°C after UV irradiation is 1 GPa or more, more preferably 1.4 GPa or more. When the tensile modulus of elasticity falls within such ranges, the photothermal conversion layer may also function as a base material. Examples of the photothermal conversion layer having such characteristics include resin films to be described later, and a resin film formed of a polyimide-based resin may be preferably used.

### B-1. Photothermal Conversion Layer that may absorb UV Light

In one embodiment, a photothermal conversion layer that may absorb UV light (hereinafter also referred to as "UV-absorbing photothermal conversion layer") is formed. For a pressure-sensitive adhesive sheet including the UV-absorbing photothermal conversion layer, a peeling operation may be performed with UV laser light. The transmittance of the UV-absorbing photothermal conversion layer for light having a wavelength of 355 nm is 50% or less, more preferably 40% or less, still more preferably 35% or less, most preferably 0%. In one embodiment, the transmittance of the photothermal conversion layer may be calculated by the expression: (total lightabsorption rate).

In one embodiment, the UV-absorbing photothermal conversion layer is a resin film. The resin film may be formed of any appropriate resin as long as the resin can absorb UV light. Examples of the resin for forming the resin film include a polyimide-based resin, a polyetheretherketone-based resin, a polyethylene naphthalate-based resin, an acrylic resin, and an epoxy-based resin. Of those, a polyimide-based resin is preferred.

A colored film colored so that predetermined UV light is absorbed may be used as the resin film. The colored film may be a film including a color printed layer, or may be a resin film containing a pigment and/or a dye. The printed layer may be formed by a method, such as gravure printing or screen printing. The thickness of the printed layer is, for example, preferably more than 0 um and 15 um or less, more preferably from 0.3 um to 10 µm, still more preferably from 0.5 um to 8 um. Further, the thickness is even still more preferably from 0.6 um to 5 µm, particularly preferably from 0.8 um to 3 um. In addition, a colored metal film may be used as the UV-absorbing photothermal conversion layer.

In another embodiment, the UV-absorbing photothermal conversion layer may be a resin layer formed by applying a composition for forming a photothermal conversion layer. The resin layer contains, for example, a UV absorber. The resin layer may be a pressure-sensitive adhesive layer containing a pressure-sensitive adhesive. Examples of the pressure-sensitive adhesive include a pressure-sensitive adhesive having pressure sensitivity and an active energy ray-curable pressure-sensitive adhesive.

### (UV Absorber)

Any appropriate UV absorber may be used as the UV absorber as long as the absorber is a compound that absorbs UV light (having a wavelength of, for example, 355 nm). Examples of the UV absorber include a benzotriazole-based UV absorber, a benzophenone-based UV absorber, a triazine-based UV absorber, a salicylate-based UV absorber, and a cyanoacrylate-based UV absorber. Of those, a triazine-based UV absorber or a benzotriazole-based UV absorber is preferred, and a triazine-based UV absorber is particularly preferred.

Examples of the hydroxyphenyltriazine-based UV absorber include a reaction product of 2-(4,6-bis(2,4-dimethylphenyl)-1,3,5-triazin-2-yl)-5-hydroxyphenyl and a [(C10-C16 (mainly C12-C13) alkyloxy)methyl]oxirane (product name: "TINUVIN 400", manufactured by BASF SE), 2-[4,6-bis(2,4-dimethylphenyl)-1,3,5-triazin-2-yl]-5-[3-(dodecyloxy)-2-hydroxypropoxy]phenol), a reaction product of 2-(2,4-dihydroxyphenyl)-4,6-bis-(2,4-dimethylphenyl)-1,3,5-triazine and (2-ethylhexyl)-glycidic acid ester (product name: "TINUVIN 405", manufactured by BASF SE), 2,4-bis(2-hydroxy-4-butoxyphenyl)-6-(2,4-dibutoxyphenyl)-1,3,5-triazine (product name: "TINUVIN 460", manufactured by BASF SE), 2-(4,6-diphenyl-1,3,5-triazin-2-yl)-5-[(hexyl)oxy]-phenol (product name: "TINUVIN 1577", manufactured by BASF SE), 2-(4,6-diphenyl-1,3,5-triazin-2-yl)-5-[2-(2-ethylhexanoyloxy)ethoxy]-phenol (product name: "ADK STAB LA-46", manufactured by ADEKA Corporation), 2-(2-hydroxy-4-[1-octyloxycarbonylethoxy]phenyl)-4,6-bis(4-phenylphenyl)-1,3,5-triazine (product name: "TINUVIN 479", manufactured by BASF SE), and a product available under the product name "TINUVIN 477" from BASF SE.

Examples of the benzotriazole-based UV absorber (benzotriazole-based compound) include 2-(2-hydroxy-5-tert-butylphenyl)-2H-benzotriazole (product name: "TINUVIN PS", manufactured by BASF SE), an ester compound of benzenepropanoic acid and 3-(2H-benzotriazol-2-yl)-5-(1,1-dimethylethyl)-4-hydroxy (C7-9 side chain and linear alkyl) (product name: "TINUVIN 384-2", manufactured by BASF SE), a mixture of octyl 3-[3-tert-butyl-4-hydroxy-5-(5-chloro-2H-benzotriazol-2-yl)phenyl] propionate and 2-ethylhexyl-3-[3-tert-butyl-4-hydroxy-5-(5-chloro-2H-benzotriazol-2-yl)phenyl] propionate (product name: "TINUVIN 109", manufactured by BASF SE), 2-(2H-benzotriazol-2-yl)-4,6-bis(1-methyl-1-phenylethyl)phenol (product name: "TINUVIN 900", manufactured by BASF SE), 2-(2H-benzotriazol-2-yl)-6-(1-methyl-1-phenylethyl)-4-(1,1,3,3-tetramethylbutyl)phenol (product name: "TINUVIN 928", manufactured by BASF SE), a reaction product of methyl 3-(3-(2H-benzotriazol-2-yl)-5-tert-butyl-4-hydroxyphenyl) propionate/polyethylene glycol 300 (product name: "TINUVIN 1130", manufactured by BASF SE), 2-(2H-benzotriazol-2-yl)-p-cresol (product name: "TINUVIN P", manufactured by BASF SE), 2-(2H-benzotriazol-2-yl)-4,6-bis(1-methyl-1-phenylethyl)phenol (product name: "TINUVIN 234", manufactured by BASF SE), 2-[5-chloro-2H-benzotriazol-2-yl]-4-methyl-6-(tert-butyl)phenol (product name: "TINUVIN 326", manufactured by BASF SE), 2-(2H-benzotriazol-2-yl)-4,6-di-tert-pentylphenol (product name: "TINUVIN 328", manufactured by BASF SE), 2-(2H-benzotriazol-2-yl)-4-(1,1,3,3-tetramethylbutyl)phenol (product name: "TINUVIN 329", manufactured by BASF SE), 2,2'-methylenebis[6-(2H-benzotriazol-2-yl)-4-(1,1,3,3-tetramethylbutyl)phenol] (product name: "TINUVIN 360", manufactured by BASF SE), a reaction product of methyl 3-(3-(2H-benzotriazol-2-yl)-5-tert-butyl-4-hydroxyphenyl) propionate and polyethylene glycol 300 (product name: "TINUVIN 213", manufactured by BASF SE), 2-(2H-benzotriazol-2-yl)-6-dodecyl-4-methylphenol (product name: "TINUVIN 571", manufactured by BASF SE), 2-[2-hydroxy-3-(3,4,5,6-tetrahydrophthalimido-methyl)-5-methylphenyl]benzotriazole (product name: "Sumisorb 250", manufactured by Sumitomo Chemical Co., Ltd.), 2-(3-tert-butyl-2-hydroxy-5-methylphenyl)-5-chloro-2H-benzotriazole (product name: "SEESORB 703", manufactured by Shipro Kasei Kaisha, Ltd.), 2-(2H-benzotriazol-2-yl)-4-methyl-6-(3,4,5,6-tetrahydrophthalimidylmethyl)phenol (product name: "SEESORB 706", manufactured by Shipro Kasei Kaisha, Ltd.), 2-(4-benzoyloxy-2-hydroxyphenyl)-5-chloro-2H-benzotriazole (product name: "SEESORB 7012BA", manufactured by Shipro Kasei Kaisha, Ltd.), 2-tert-butyl-6-(5-chloro-2H-benzotriazol-2-yl)-4-methylphenol (product name: "KEMISORB 73", manufactured by Chemipro Kasei Kaisha, Ltd.), 2,2'-methylenebis[6-(2H-benzotriazol-2-yl)-4-tert-octylphenol] (product name: "ADK STAB LA-31", manufactured by ADEKA Corporation), 2-(2H-benzotriazol-2-yl)-p-cellulose (product name: "ADK STAB LA-32", manufactured by ADEKA Corporation), and 2-(5-chloro-2H-benzotriazol-2-yl)-6-tert-butyl-4-methylphenol (product name: "ADK STAB LA-36", manufactured by ADEKA Corporation).

The UV absorber may be a dye or a pigment. Examples of the pigment include azo-based, phthalocyanine-based, anthraquinone-based, lake-based, perylene-based, perinone-based, quinacridone-based, thioindigo-based, dioxazine-based, isoindolinone-based, and quinophthalone-based pigments. Examples of the dye include azo-based, phthalocyanine-based, anthraquinone-based, carbonyl-based, indigo-based, quinone imine-based, methine-based, quinoline-based, and nitro-based dyes.

The molecular weight of the compound for forming the UV absorber is preferably from 100 to 1,500, more preferably from 200 to 1,200, still more preferably from 200 to 1,000.

The maximum absorption wavelength of the UV absorber is preferably from 300 nm to 450 nm, more preferably from 320 nm to 400 nm, still more preferably from 330 nm to 380 nm. A difference between the maximum absorption wavelength of the UV absorber and the maximum absorption wavelength of the photopolymerization initiator is preferably 10 nm or more, more preferably 25 nm or more.

The content of the UV absorber is preferably from 1 part by weight to 50 parts by weight, more preferably from 5 parts by weight to 20 parts by weight with respect to 100 parts by weight of a base polymer in the UV-absorbing photothermal conversion layer.

Examples of the pressure-sensitive adhesive having pressure sensitivity include an acrylic pressure-sensitive adhesive, a rubber-based pressure-sensitive adhesive, a vinyl alkyl ether-based pressure-sensitive adhesive, a silicone-based pressure-sensitive adhesive, a polyester-based pressure-sensitive adhesive, a polyamide-based pressure-sensitive adhesive, a urethane-based pressure-sensitive adhesive, and a styrene-diene block copolymer-based pressure-sensitive adhesive. Of those, an acrylic pressure-sensitive adhesive or a rubber-based pressure-sensitive adhesive is preferred, and an acrylic pressure-sensitive adhesive is more preferred. Those pressure-sensitive adhesives may be used alone or in combination thereof.

An example of the acrylic pressure-sensitive adhesive is an acrylic pressure-sensitive adhesive containing, as a base polymer, an acrylic polymer (homopolymer or copolymer) using one kind or two or more kinds of (meth)acrylic acid alkyl esters as a monomer component. Examples of the acrylic polymer include: homopolymers or copolymers of hydrocarbon group-containing (meth)acrylic acid esters, such as a (meth)acrylic acid alkyl ester, a (meth)acrylic acid cycloalkyl ester, and a (meth)acrylic acid aryl ester; and copolymers of the hydrocarbon group-containing (meth)acrylic acid esters and other copolymerizable monomers. Specific examples of the (meth)acrylic acid alkyl ester include (meth)acrylic acid C1-20 alkyl esters, such as methyl (meth)acrylate, ethyl (meth)acrylate, propyl (meth)acrylate, isopropyl (meth)acrylate, butyl (meth)acrylate, isobutyl (meth)acrylate, s-butyl (meth)acrylate, t-butyl (meth)acrylate, pentyl (meth)acrylate, hexyl (meth)acrylate, heptyl (meth)acrylate, octyl (meth)acrylate, 2-ethylhexyl (meth)acrylate, isooctyl (meth)acrylate, nonyl (meth)acrylate, isononyl (meth)acrylate, decyl (meth)acrylate, isodecyl (meth)acrylate, undecyl (meth)acrylate, dodecyl (meth)acrylate, tridecyl (meth)acrylate, tetradecyl (meth)acrylate, pentadecyl (meth)acrylate, hexadecyl (meth)acrylate, heptadecyl (meth)acrylate, octadecyl (meth)acrylate, nonadecyl (meth)acrylate, and eicosyl (meth)acrylate. Of those, a (meth)acrylic acid alkyl ester having a linear or branched alkyl group having 4 to 18 carbon atoms may be preferably used.

Examples of the other copolymerizable monomer include functional group-containing monomers, such as a carboxy group-containing monomer, an acid anhydride monomer, a hydroxy group-containing monomer, a glycidyl group-containing monomer, a sulfonic acid group-containing monomer, a phosphoric acid group-containing monomer, an acrylamide, and acrylonitrile. Examples of the carboxy group-containing monomer include acrylic acid, methacrylic acid, carboxyethyl (meth)acrylate, carboxypentyl (meth)acrylate, itaconic acid, maleic acid, fumaric acid, and crotonic acid. Examples of the acid anhydride monomer include maleic anhydride and itaconic anhydride. Examples of the hydroxy group-containing monomer include 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, and (4-hydroxymethylcyclohexyl)methyl (meth)acrylate. Examples of the glycidyl group-containing monomer include glycidyl (meth)acrylate and methylglycidyl (meth)acrylate. Examples of the sulfonic acid group-containing monomer include styrenesulfonic acid, allylsulfonic acid, 2-(meth)acrylamido-2-methylpropanesulfonic acid, (meth)acrylamidopropanesulfonic acid, sulfopropyl (meth)acrylate, and (meth)acryloyloxynaphthalenesulfonic acid. An example of the phosphoric acid group-containing monomer is 2-hydroxyethylacryloyl phosphate. An example of the acrylamide is N-acryloylmorpholine. Those monomers may be used alone or in combination thereof. The content of a constituent unit derived from the copolymerizable monomer is preferably 60 parts by weight or less, more preferably 40 parts by weight or less with respect to 100 parts by weight of the base polymer.

Examples of the rubber-based pressure-sensitive adhesive include rubber-based pressure-sensitive adhesives containing, as base polymers: natural rubbers; synthetic rubbers, such as a polyisoprene rubber, a styrene-butadiene (SB) rubber, a styrene-isoprene (SI) rubber, a styrene-isoprene-styrene block copolymer (SIS) rubber, a styrene-butadiene-styrene block copolymer (SBS) rubber, a styrene-ethylene-butylene-styrene block copolymer (SEBS) rubber, a styrene-ethylene-propylene-styrene block copolymer (SEPS) rubber, a styrene-ethylenepropylene block copolymer (SEP) rubber, a reclaimed rubber, a butyl rubber, polyisobutylene, and modified products thereof; and the like.

The pressure-sensitive adhesive having pressure sensitivity may contain any appropriate additive as required. Examples of the additive include a cross-linking agent, a tackifier (e.g., a rosin-based tackifier, a terpene-based tackifier, or a hydrocarbon-based tackifier), a plasticizer (e.g., a trimellitic acid ester-based plasticizer or a pyromellitic acid ester-based plasticizer), a pigment, a dye, an age resistor, a conductive material, an antistatic agent, a light stabilizer, a peeling modifier, a softener, a surfactant, a flame retardant, and an antioxidant.

Examples of the active energy ray-curable pressure-sensitive adhesive include pressure-sensitive adhesives described in the section C to be described later.

### B-2. Photothermal Conversion Layer that may absorb IR Light

In one embodiment, a photothermal conversion layer that may absorb IR light (hereinafter also referred to as "IR-absorbing photothermal conversion layer") is formed. In one embodiment, for a pressure-sensitive adhesive sheet including the IR-absorbing photothermal conversion layer, a peeling operation may be performed with IR laser light. The transmittance of the IR-absorbing photothermal conversion layer for light having a wavelength of 1,032 nm is 50% or less, more preferably 40% or less, still more preferably 35% or less, most preferably 0%. The IR-absorbing photothermal conversion layer may be a layer that may further absorb UV light, and in this case, the peeling operation may be performed with not only IR laser light but also UV laser light.

In one embodiment, the IR-absorbing photothermal conversion layer is formed of a resin film. In one embodiment, a colored film containing a predetermined colorant (pigment or dye) may be used as the resin film so that IR light having a predetermined wavelength is absorbed. The colored film serving as the IR-absorbing photothermal conversion layer may be a film (e.g., a monolayer film) in a state in which a colorant is incorporated in a resin, or may be a film formed of a layer (e.g., a printed layer) containing a predetermined colorant and a resin layer. When the layer containing a colorant is formed, the layer containing a colorant and the thermal decomposition layer are preferably adjacent to each other. Any appropriate colorant is used as the colorant in any appropriate blending amount as long as IR light absorbability can be imparted. For example, carbon black, cesium tungsten oxide, lanthanum hexaboride, tin-doped indium oxide, antimony-doped tin oxide, a cyanine compound, a phthalocyanine compound, a dithiol metal complex, a naphthoquinone compound, a diimmonium compound, or an azo compound is used as the colorant. Examples of the resin for forming the resin film include a polyimide-based resin, a polyethylene terephthalate-based resin, a polyamide-based resin, a polyetheretherketone-based resin, a polyethylene naphthalate-based resin, an acrylic resin, and an epoxy-based resin. Of those, a polyimide-based resin or a polyethylene terephthalate-based resin is preferred. In addition, a colored metal film (e.g., a metal film including a color printed layer) may be used as the IR-absorbing photothermal conversion layer. A method of forming the printed layer is as described above.

### C. Thermal Decomposition Layer

The 5% weight loss temperature of the thermal decomposition layer after UV irradiation is preferably from 250°C to 400°C, more preferably from 280°C to 370°C. When the 5% weight loss temperature falls within such ranges, the above-mentioned effect of the present invention becomes significant. The 5% weight loss temperature of the thermal decomposition layer after UV irradiation may be adjusted by, for example, the kind or structure of a resin for forming the thermal decomposition layer (a base polymer of the pressure-sensitive adhesive), a cross-linking degree, or the presence or absence or kind of the additive. When the 5% weight loss temperature after UV irradiation is too low, that is, when heat resistance is too low, excessive decomposition occurs over the entirety of the thermal decomposition layer when laser light irradiation is performed, and separation of the electronic part from the support may be inhibited.

The strain at break of the thermal decomposition layer after UV irradiation is preferably 50% or more, more preferably from 50% to 400%, still more preferably from 70% to 200%. When the strain at break falls within such ranges, after the separation of the electronic part from the support, the thermal decomposition layer remaining as a residue on the support can be easily peeled. The term "strain at break after UV irradiation" as used herein means a strain at break measured after irradiation with light having a wavelength of 365 nm at an integrated light quantity of 1,380 mJ/cm². The strain at break is measured by a tensile test at 23°C based on JIS K 7161:1994 or JIS K 7127:1999. The strain at break (%) is determined by (length (mm) of breaking point-length (mm) of initial test piece)÷length (mm) of initial test piece. The strain at break of the thermal decomposition layer may be adjusted by, for example, the kind and blending ratio of an active energy ray-reactive compound (monomer or oligomer) in the active energy ray-curable pressure-sensitive adhesive.

The tensile modulus of elasticity at 25°C of the thermal decomposition layer after UV irradiation is preferably from 5 MPa to 2 GPa, more preferably from 10 MPa to 1 GPa. When the tensile modulus of elasticity falls within such ranges, after the separation of the electronic part from the support, the thermal decomposition layer remaining as a residue on the support can be easily peeled.

The thickness of the thermal decomposition layer is preferably from 10 um to 200 µm, more preferably from 20 um to 150 µm, still more preferably from 30 um to 100 µm.

In one embodiment, the transmittance of the thermal decomposition layer for light having a wavelength of 355 nm is 80% or more, more preferably from 82% to 98%, still more preferably from 85% to 97%. When the transmittance falls within such ranges, at the time of the peeling by irradiation with UV laser light, the laser light can be caused to preferably reach the photothermal conversion layer, and the peeling at the interface between the thermal decomposition layer and the photothermal conversion layer of the photothermal conversion layer is promoted.

In one embodiment, the transmittance of the thermal decomposition layer for light having a wavelength of 1,032 nm is 80% or more, more preferably from 85% to 98%, still more preferably from 90% to 96%. When the transmittance falls within such ranges, at the time of the peeling by irradiation with IR laser light, the laser light can be caused to preferably reach the photothermal conversion layer, and the peeling at the interface between the thermal decomposition layer and the photothermal conversion layer of the photothermal conversion layer is promoted.

The thermal decomposition layer preferably contains the active energy ray-curable pressure-sensitive adhesive. When the active energy ray-curable pressure-sensitive adhesive is used, a thermal decomposition layer excellent in heat resistance can be formed. The thermal decomposition layer containing the active energy ray-curable pressure-sensitive adhesive may be cured by active energy ray irradiation to be reduced in pressure-sensitive adhesive strength. In one embodiment, when the entirety of the thermal decomposition layer is irradiated with an active energy ray (typically, UV light) before the laser light irradiation, more preferred peelability (in particular, peelability of the thermal decomposition layer from the support) can be exhibited. The thermal decomposition layer is preferably free of a UV absorber. When the thermal decomposition layer is formed with use of the active energy ray-curable pressure-sensitive adhesive and without incorporation of the UV absorber, a pressure-sensitive adhesive sheet that can be peeled with a reduced amount of residue can be obtained.

### (Active Energy Ray-curable Pressure-sensitive Adhesive)

In one embodiment, an active energy ray-curable pressure-sensitive adhesive (A1), which contains a base polymer serving as a parent agent and an active energy ray-reactive compound (monomer or oligomer), is used as the active energy ray-curable pressure-sensitive adhesive. In another embodiment, an active energy ray-curable pressure-sensitive adhesive (A2) containing an active energy ray-reactive polymer as a base polymer is used. In one embodiment, the base polymer preferably has a functional group that may be cleaved by a photopolymerization initiator. An example of the functional group is a functional group having a carbon-carbon double bond. Examples of the active energy ray include a gamma ray, UV light, visible light, an infrared ray (heat ray), a radio wave, an alpha ray, a beta ray, an electron beam, a plasma flow, an ionizing ray, and a particle beam. Of those, UV light is preferred.

The active energy ray-curable pressure-sensitive adhesive (A1) is preferably used. When the active energy ray-curable pressure-sensitive adhesive (A1) containing an active energy ray-reactive compound (monomer or oligomer) is used, a thermal decomposition layer excellent in peelability from the support can be formed.

Examples of the base polymer to be used in the pressure-sensitive adhesive (A1) include: rubber-based polymers, such as a natural rubber, a polyisobutylene rubber, a styrene-butadiene rubber, a styrene-isoprene-styrene block copolymer rubber, a reclaimed rubber, a butyl rubber, a polyisobutylene rubber, and a nitrile rubber (NBR); silicone-based polymers; and acrylic polymers. Those polymers may be used alone or in combination thereof. Of those, an acrylic polymer is preferred.

Examples of the acrylic polymer include: homopolymers or copolymers of hydrocarbon group-containing (meth) acrylic acid esters, such as a (meth) acrylic acid alkyl ester, a (meth)acrylic acid cycloalkyl ester, and a (meth)acrylic acid aryl ester; and copolymers of the hydrocarbon group-containing (meth)acrylic acid esters and other copolymerizable monomers. Specific examples of the (meth)acrylic acid alkyl ester include (meth)acrylic acid C1-20 alkyl esters, such as methyl (meth)acrylate, ethyl (meth)acrylate, propyl (meth)acrylate, isopropyl (meth)acrylate, butyl (meth)acrylate, isobutyl (meth)acrylate, s-butyl (meth)acrylate, t-butyl (meth)acrylate, pentyl (meth)acrylate, hexyl (meth)acrylate, heptyl (meth)acrylate, octyl (meth)acrylate, 2-ethylhexyl (meth)acrylate, isooctyl (meth)acrylate, nonyl (meth)acrylate, isononyl (meth)acrylate, decyl (meth)acrylate, isodecyl (meth)acrylate, undecyl (meth)acrylate, dodecyl (meth)acrylate, tridecyl (meth)acrylate, tetradecyl (meth)acrylate, pentadecyl (meth)acrylate, hexadecyl (meth)acrylate, heptadecyl (meth)acrylate, octadecyl (meth)acrylate, nonadecyl (meth)acrylate, and eicosyl (meth)acrylate. Of those, a (meth)acrylic acid alkyl ester having a linear or branched alkyl group having 4 to 18 carbon atoms may be preferably used.

Examples of the other copolymerizable monomer include functional group-containing monomers, such as a carboxy group-containing monomer, an acid anhydride monomer, a hydroxy group-containing monomer, a glycidyl group-containing monomer, a sulfonic acid group-containing monomer, a phosphoric acid group-containing monomer, an acrylamide, and acrylonitrile. Examples of the carboxy group-containing monomer include acrylic acid, methacrylic acid, carboxyethyl (meth)acrylate, carboxypentyl (meth)acrylate, itaconic acid, maleic acid, fumaric acid, and crotonic acid. Examples of the acid anhydride monomer include maleic anhydride and itaconic anhydride. Examples of the hydroxy group-containing monomer include 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, and (4-hydroxymethylcyclohexyl)methyl (meth)acrylate. Examples of the glycidyl group-containing monomer include glycidyl (meth)acrylate and methylglycidyl (meth)acrylate. Examples of the sulfonic acid group-containing monomer include styrenesulfonic acid, allylsulfonic acid, 2-(meth)acrylamido-2-methylpropanesulfonic acid, (meth)acrylamidopropanesulfonic acid, sulfopropyl (meth)acrylate, and (meth)acryloyloxynaphthalenesulfonic acid. An example of the phosphoric acid group-containing monomer is 2-hydroxyethylacryloyl phosphate. An example of the acrylamide is N-acryloylmorpholine. Those monomers may be used alone or in combination thereof. The content of a constituent unit derived from the copolymerizable monomer is preferably 60 parts by weight or less, more preferably 40 parts by weight or less with respect to 100 parts by weight of the base polymer.

The acrylic polymer may contain a constituent unit derived from a polyfunctional monomer. Examples of the polyfunctional monomer include hexanediol di(meth)acrylate, (poly)ethylene glycol di(meth)acrylate, (poly)propylene glycol di(meth)acrylate, neopentyl glycol di(meth)acrylate, pentaerythritol di(meth)acrylate, trimethylolpropane tri(meth)acrylate, pentaerythritol tri(meth)acrylate, dipentaerythritol hexa(meth)acrylate, epoxy (meth)acrylate (i.e., polyglycidyl (meth)acrylate), polyester (meth)acrylate, and urethane (meth)acrylate. Those monomers may be used alone or in combination thereof. The content of the constituent unit derived from the polyfunctional monomer is preferably 40 parts by weight or less, more preferably 30 parts by weight or less with respect to 100 parts by weight of the base polymer.

The weight-average molecular weight of the acrylic polymer is preferably from 100,000 to 3,000,000, more preferably from 200,000 to 2,000,000. The weight-average molecular weight may be measured by GPC (solvent: THF).

The active energy ray-reactive compound that may be used in the pressure-sensitive adhesive (A1) is, for example, a photoreactive monomer or oligomer having a functional group having a polymerizable carbon-carbon multiple bond, such as an acryloyl group, a methacryloyl group, a vinyl group, an allyl group, or an acetylene group. Specific examples of the photoreactive monomer include: esterified products of (meth)acrylic acid and polyhydric alcohols, such as trimethylolpropane tri(meth)acrylate, tetramethylolmethane tetra(meth)acrylate, pentaerythritol tri(meth)acrylate, pentaerythritol tetra(meth)acrylate, dipentaerythritol monohydroxypenta(meth)acrylate, dipentaerythritol hexa(meth)acrylate, 1,4-butanediol di(meth)acrylate, 1,6-hexanediol di(meth)acrylate, and polyethylene glycol di(meth)acrylate; polyfunctional urethane (meth)acrylates; epoxy (meth)acrylates; and oligoester (meth)acrylates. In addition, a monomer, such as methacryloisocyanate, 2-methacryloyloxyethyl isocyanate (2-isocyanatoethyl methacrylate), or m-isopropenyl-α,α-dimethylbenzyl isocyanate, may be used. Specific examples of the photoreactive oligomer include dimers to pentamers of the above-mentioned monomers. The molecular weight of the photoreactive oligomer is preferably from 100 to 3,000. In one embodiment, a plurality of kinds of the active energy ray-reactive compounds may be used in combination. The peelability may be controlled by the combination of the plurality of kinds of the active energy ray-reactive compounds. In one embodiment, the 5% weight loss temperature after UV irradiation may be adjusted by the number of functional groups of the active energy ray-reactive compound.

In addition, a monomer, such as epoxidized butadiene, glycidyl methacrylate, an acrylamide, or a vinylsiloxane, or an oligomer formed of the monomer may be used as the active energy ray-reactive compound.

The content of the active energy ray-reactive compound in the pressure-sensitive adhesive (A1) is preferably from 0.1 part by weight to 500 parts by weight, more preferably from 5 parts by weight to 300 parts by weight, still more preferably from 40 parts by weight to 150 parts by weight with respect to 100 parts by weight of the base polymer.

The active energy ray-reactive polymer (base polymer) in the pressure-sensitive adhesive (A2) is, for example, a polymer having a functional group having a carbon-carbon multiple bond, such as an acryloyl group, a methacryloyl group, a vinyl group, an allyl group, or an acetylene group. Specific examples of the active energy ray-reactive polymer include: polymers formed of polyfunctional (meth)acrylates; photocationically polymerizable polymers; cinnamoyl group-containing polymers such as polyvinyl cinnamate; diazotized amino novolac resins; and polyacrylamide. The 5% weight loss temperature after UV irradiation may be adjusted by the amount of a functional group having a carbon-carbon multiple bond.

In one embodiment, there is used an active energy ray-reactive polymer formed by introducing an active energy raypolymerizable carbon-carbon multiple bond into a side chain of the acrylic polymer, a main chain thereof, and/or a terminal of the main chain. An approach to introducing a radiation-polymerizable carbon-carbon double bond into the acrylic polymer is, for example, a method including: copolymerizing raw material monomers including a monomer having a predetermined functional group (first functional group) to provide the acrylic polymer; and then subjecting a compound having a predetermined functional group (second functional group) that can react with the first functional group to be bonded thereto and the radiation-polymerizable carbon-carbon double bond to a condensation reaction or an addition reaction with the acrylic polymer while maintaining the radiation polymerizability of the carbon-carbon double bond. The 5% weight loss temperature after UV irradiation may be adjusted by the amount of a carbon-carbon multiple bond.

Examples of the combination of the first functional group and the second functional group include: a carboxy group and an epoxy group; an epoxy group and a carboxy group; a carboxy group and an aziridyl group; an aziridyl group and a carboxy group; a hydroxy group and an isocyanate group; and an isocyanate group and a hydroxy group. Of those combinations, the combination of a hydroxy group and an isocyanate group or the combination of an isocyanate group and a hydroxy group is preferred from the viewpoint of the ease with which a reaction between the groups is tracked. In addition, technical difficulty in producing a polymer having an isocyanate group having high reactivity is high, and hence a case in which the first functional group of the acrylic polymer side is a hydroxy group and the second functional group is an isocyanate group is more preferred from the viewpoint of the ease with which the acrylic polymer is produced or obtained. In this case, examples of an isocyanate compound having both of a radiation-polymerizable carbon-carbon double bond and an isocyanate group serving as the second functional group include methacryloyl isocyanate, 2-methacryloyloxyethyl isocyanate, and m-isopropenyl-α,α-dimethylbenzyl isocyanate. In addition, a polymer containing a constituent unit derived from the above-mentioned hydroxy group-containing monomer is preferred as the acrylic polymer having the first functional group, and a polymer containing a constituent unit derived from an ether-based compound, such as 2-hydroxyethyl vinyl ether, 4-hydroxybutyl vinyl ether, or diethylene glycol monovinyl ether, is also preferred.

The pressure-sensitive adhesive (A2) may further contain the active energy ray-reactive compound (monomer or oligomer).

The active energy ray-curable pressure-sensitive adhesive may contain the photopolymerization initiator.

Any appropriate initiator may be used as the photopolymerization initiator. Examples of the photopolymerization initiator include: α-ketol-based compounds, such as 4-(2-hydroxyethoxy)phenyl(2-hydroxy-2-propyl) ketone, α-hydroxy-α,α'-dimethylacetophenone, 2-methyl-2-hydroxypropiophenone, and 1-hydroxycyclohexyl phenyl ketone; acetophenone-based compounds, such as methoxyacetophenone, 2,2-dimethoxy-2-phenylacetophenone, 2,2-diethoxyacetophenone, and 2-methyl-1-[4-(methylthio)-phenyl]-2-morpholinopropane-1; benzoin ether-based compounds, such as benzoin ethyl ether, benzoin isopropyl ether, and anisoin methyl ether; ketal-based compounds such as benzyl dimethyl ketal; aromatic sulfonyl chloride-based compounds such as 2-naphthalenesulfonyl chloride; photoactive oxime-based compounds such as 1-phenone-1,1-propanedione-2-(o-ethoxycarbonyl)oxime; benzophenone-based compounds, such as benzophenone, benzoylbenzoic acid, and 3,3'-dimethyl-4-methoxybenzophenone; thioxanthone-based compounds, such as thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, and 2,4-diisopropylthioxanthone; camphorquinone; halogenated ketones; acylphosphinoxides; and acylphosphonates. The usage amount of the photopolymerization initiator may be set to any appropriate amount.

In one embodiment, the active energy ray-curable pressure-sensitive adhesive may contain a photosensitizer.

The active energy ray-curable pressure-sensitive adhesive preferably contains a cross-linking agent. Examples of the cross-linking agent include an isocyanate-based cross-linking agent, an epoxy-based cross-linking agent, an oxazolinebased cross-linking agent, an aziridine-based cross-linking agent, a melamine-based cross-linking agent, a peroxide-based cross-linking agent, a urea-based cross-linking agent, a metal alkoxide-based cross-linking agent, a metal chelate-based cross-linking agent, a metal salt-based cross-linking agent, a carbodiimide-based cross-linking agent, and an amine-based cross-linking agent.

The content of the cross-linking agent is preferably from 0.01 part by weight to 20 parts by weight with respect to 100 parts by weight of the base polymer of the pressure-sensitive adhesive.

In one embodiment, an epoxy-based cross-linking agent is preferably used. When the epoxy-based cross-linking agent is used, a thermal decomposition layer having a high 5% weight loss temperature after UV irradiation can be formed. Examples of the epoxy-based cross-linking agent include N,N,N',N'-tetraglycidyl-m-xylenediamine, diglycidylaniline, 1,3-bis(N,N-glycidylaminomethyl)cyclohexane (manufactured by Mitsubishi Gas Chemical Company, Inc., product name: "TETRAD-C"), 1,6-hexanediol diglycidyl ether (manufactured by Kyoeisha Chemical Co., Ltd., product name: "Epolight 1600"), neopentyl glycol diglycidyl ether (manufactured by Kyoeisha Chemical Co., Ltd., product name: "Epolight 1500NP"), ethylene glycol diglycidyl ether (manufactured by Kyoeisha Chemical Co., Ltd., product name: "Epolight 40E"), propylene glycol diglycidyl ether (manufactured by Kyoeisha Chemical Co., Ltd., product name: "Epolight 70P"), polyethylene glycol diglycidyl ether (manufactured by NOF Corporation, product name: "EPIOL E-400"), polypropylene glycol diglycidyl ether (manufactured by NOF Corporation, product name: "EPIOL P-200"), sorbitol polyglycidyl ether (manufactured by Nagase ChemteX Corporation, product name: "Denacol EX-611"), glycerol polyglycidyl ether (manufactured by Nagase ChemteX Corporation, product name: "Denacol EX-314"), pentaerythritol polyglycidyl ether, polyglycerol polyglycidyl ether (manufactured by Nagase ChemteX Corporation, product name: "Denacol EX-512"), sorbitan polyglycidyl ether, trimethylolpropane polyglycidyl ether, adipic acid diglycidyl ester, o-phthalic acid diglycidyl ester, triglycidyl-tris(2-hydroxyethyl)isocyanurate, resorcin diglycidyl ether, bisphenol-S-diglycidyl ether, and an epoxy-based resin having two or more epoxy groups in a molecule thereof. The content of the epoxy-based cross-linking agent may be set to any appropriate amount in accordance with desired characteristics, and is typically from 0.01 part by weight to 10 parts by weight, more preferably from 0.05 part by weight to 7 parts by weight with respect to 100 parts by weight of the base polymer.

In one embodiment, an isocyanate-based cross-linking agent is preferably used. Specific examples of the isocyanate-based cross-linking agent include: lower aliphatic polyisocyanates, such as butylene diisocyanate and hexamethylene diisocyanate; alicyclic isocyanates, such as cyclopentylene diisocyanate, cyclohexylene diisocyanate, and isophorone diisocyanate; aromatic isocyanates, such as 2,4-tolylene diisocyanate, 4,4'-diphenylmethane diisocyanate, and xylylene diisocyanate; and isocyanate adducts, such as a trimethylolpropane/tolylene diisocyanate trimer adduct (manufactured by Nippon Polyurethane Industry Co., Ltd., product name: "CORONATE L"), a trimethylolpropane/hexamethylene diisocyanate trimer adduct (manufactured by Nippon Polyurethane Industry Co., Ltd., product name: "CORONATE HL"), and an isocyanurate form of hexamethylene diisocyanate (manufactured by Nippon Polyurethane Industry Co., Ltd., product name: "CORONATE HX") . Of those, a cross-linking agent having 3 or more isocyanate groups is preferably used. The content of the isocyanate-based cross-linking agent may be set to any appropriate amount in accordance with desired characteristics, and is typically from 0.1 part by weight to 20 parts by weight, more preferably from 0.5 part by weight to 10 parts by weight with respect to 100 parts by weight of the base polymer.

The active energy ray-curable pressure-sensitive adhesive may further contain any appropriate additive as required. Examples of the additive include an active energy ray polymerization accelerator, a radical scavenger, a tackifier, a plasticizer (e.g., a trimellitate-based plasticizer or a pyromellitate-based plasticizer), a pigment, a dye, a filler, an age resistor, a conductive material, an antistatic agent, a UV absorber, a light stabilizer, a peeling modifier, a softener, a surfactant, a flame retardant, and an antioxidant.

### D. Pressure-sensitive Adhesive Layer (Other Layer)

As described above, in one embodiment, the pressure-sensitive adhesive layer may be arranged on the surface of the photothermal conversion layer on the opposite side to the thermal decomposition layer. The pressure-sensitive adhesive layer contains any appropriate pressure-sensitive adhesive. For example, the pressure-sensitive adhesive layer contains the above-mentioned pressure-sensitive adhesive having pressure sensitivity. In one embodiment, a heat-resistant pressure-sensitive adhesive is used as the pressure-sensitive adhesive in the pressure-sensitive adhesive layer. When the pressure-sensitive adhesive sheet includes the pressure-sensitive adhesive layer formed of the heat-resistant pressure-sensitive adhesive, scorching (adhesive residue) on a workpiece (device) can be suppressed when the sheet is irradiated with laser light. Herein, the heat-resistant pressure-sensitive adhesive means a pressure-sensitive adhesive having a predetermined pressure-sensitive adhesive strength under an environment at 260°C. The heat-resistant pressure-sensitive adhesive may be preferably used without causing an adhesive residue under an environment at 260°C. The heat-resistant pressure-sensitive adhesive preferably contains, for example, an acrylic resin or a silicone-based resin as the base polymer.

### E. Method of producing Pressure-sensitive Adhesive Sheet

The pressure-sensitive adhesive sheet of the present invention may be produced by any appropriate method. The pressure-sensitive adhesive sheet of the present invention may be formed by, for example, applying a composition for forming a thermal decomposition layer (preferably an active energy ray-curable pressure-sensitive adhesive) to a resin film serving as a photothermal conversion layer. In addition, the pressure-sensitive adhesive sheet may be obtained by bonding a thermal decomposition layer formed on another base material to a photothermal conversion layer. In addition, the pressure-sensitive adhesive sheet may be formed by bonding a photothermal conversion layer formed by applying a composition for forming a photothermal conversion layer to a predetermined base material and a thermal decomposition layer formed by applying the composition for forming a thermal decomposition layer to another base material. Various methods, such as bar coater coating, air knife coating, gravure coating, gravure reverse coating, reverse roll coating, lip coating, die coating, dip coating, offset printing, flexographic printing, and screen printing, may each be adopted as a method for the application. When the composition for forming a photothermal conversion layer contains the active energy ray-reactive compound, an application layer of the composition for forming a photothermal conversion layer may be irradiated with an active energy ray such as UV light. Conditions for the irradiation may be set to any appropriate conditions in accordance with the composition of the composition for forming a photothermal conversion layer.

### F. Use of Pressure-sensitive Adhesive Sheet for temporarily fixing Electronic Part

In one embodiment, as described above, the pressure-sensitive adhesive sheet 100 is arranged on the support 200 so that the thermal decomposition layer side is on the support 200 side, and the electronic part 300 serving as a workpiece is further arranged on the side of the pressure-sensitive adhesive sheet 100 opposite to the support 200 (FIG. **2(a)**). When the pressure-sensitive adhesive sheet 100 arranged on the support 200 is irradiated with laser light, the photothermal conversion layer 10 generates heat, and the generated heat propagates to the thermal decomposition layer 20, which is adjacent thereto, and hence the thermal decomposition layer 20 starts to be decomposed, for example, locally, at the interface with the photothermal conversion layer 10 (FIG. 2(b)). As a result, the thermal decomposition layer 20 changes its form at the interface with the photothermal conversion layer 10 to lose its pressure-sensitive adhesive property, and hence the photothermal conversion layer 10 is peeled from the support 200 (FIG. 2(c)). Next, the thermal decomposition layer 20 on the support 200 is peeled. Thus, the clean support 200 suppressed in a residue can be recovered (FIG. **2(d)**) . The thermal decomposition layer preferably includes the active energy ray-curable pressure-sensitive adhesive, and the entirety of the thermal decomposition layer is irradiated with an active energy ray such as UV light before the irradiation of the pressure-sensitive adhesive sheet 100 with laser light. Through the irradiation with the active energy ray, peelability (in particular, peelability at the time of the separation of the electronic part from the support) of the thermal decomposition layer can be controlled. Conditions for the irradiation may be set to any appropriate conditions in accordance with the configuration of the thermal decomposition layer.

Examples of the electronic part serving as the workpiece include a semiconductor wafer, a semiconductor package, a semiconductor chip, an insulating material for a circuit board, a die attach film, and a ceramic material. A plurality of the electronic parts may be arranged, or one of the electronic parts may be arranged.

The electronic part may be bonded to the pressure-sensitive adhesive sheet via, for example, a pressure-sensitive adhesive layer arranged on the side of the photothermal conversion layer opposite to the thermal decomposition layer.

The electronic part may be subjected to predetermined treatment after the electronic part is arranged on the pressure-sensitive adhesive sheet (i.e., the state of FIG. 2(a)). Examples of the treatment include grinding, dicing, die bonding, wire bonding, etching, vapor deposition, molding, rewire formation, through-hole formation, and protection of a device surface.

Laser light having any appropriate wavelength is used as the laser light in accordance with the configuration of the pressure-sensitive adhesive sheet. Conditions for the irradiation with the laser light may also be set to any appropriate conditions in accordance with the configuration of the pressure-sensitive adhesive sheet. In one embodiment, UV laser light is used as the laser light. The wavelength of the UV laser light is preferably from 150 nm to 380 nm, more preferably from 240 nm to 360 nm. The output of the UV laser light is, for example, from 0.1 W to 2.0 W. In another embodiment, IR laser light is used as the laser light. The wavelength of the IR laser light is preferably from 800 nm to 10,600 nm, more preferably from 900 nm to 1,200 nm. The output of the IR laser light is, for example, from 0.01 W to 10 W.

### Examples

Now, the present invention is specifically described by way of Examples. However, the present invention is by no means limited to these Examples. Evaluation methods in Examples are as described below. In addition, in Examples, the terms "part(s)" and "%" are by weight unless otherwise stated.

### [Evaluation]

### (1) Tensile Modulus of Elasticity at 200°C of Photothermal Conversion Layer after UV Irradiation

UV light (specific wavelength: 365 nm, integrated light quantity: 1,380 mJ/cm²) of a high-pressure mercury lamp was applied once from one side to each of the photothermal conversion layers obtained in Examples and Comparative Examples. Thus, an evaluation sample was obtained. The tensile modulus of elasticity at 200°C of the evaluation sample was measured with a dynamic viscoelasticity-measuring apparatus (manufactured by TA Instruments, product name: "RSA-3") under the following conditions.
Measurement frequency: 1 Hz
Strain: 0.05%
Chuck-to-chuck distance: 20 mm
Sample width: 10 mm
Rate of temperature increase from 0°C to 250°C of 5°C/min

### (2) Tensile Modulus of Elasticity at 25°C of Thermal Decomposition Layer after UV Irradiation

UV light (specific wavelength: 365 nm, integrated light quantity: 1,380 mJ/cm²) of a high-pressure mercury lamp was applied once from one side to each of the thermal decomposition layers obtained in Examples and Comparative Examples. Thus, an evaluation sample was obtained. The tensile modulus of elasticity at 25°C of the evaluation sample was measured with a dynamic viscoelasticity-measuring apparatus (manufactured by TA Instruments, product name: "RSA-3") under the same conditions as in the above-mentioned item (1).

### (3) 5% Weight Loss Temperatures of Photothermal Conversion Layer and Thermal Decomposition Layer after UV Irradiation

The photothermal conversion layer and the thermal decomposition layer after UV light (specific wavelength: 365 nm, integrated light quantity: 1,380 mJ/cm²) of a high-pressure mercury lamp was applied once from one side to each of the pressure-sensitive adhesive sheets obtained in Examples and Comparative Examples were each used as an evaluation sample.

The temperature at which the weight loss of the evaluation sample became 5% was measured with a differential thermal analyzer (manufactured by TA Instruments, product name: "Discovery TGA") at a rate of temperature increase of 10°C/min and a flow rate of 25 ml/min under a N₂ atmosphere.

Specifically, about 0.01 g of the evaluation sample was set in the analyzer. An influence of moisture incorporated therein was removed by increasing the temperature from 20°C to 110°C once at the above-mentioned rate of temperature increase and then decreasing the temperature from 110°C to 20°C at a rate of temperature decrease of 10°C/min. The weight loss of the evaluation sample was measured while its temperature was increased again from 20°C to 500°C at the above-mentioned rate of temperature increase. The temperature at which the weight loss became 5% was extracted from the obtained data.

### (4) Light Transmittances of Photothermal Conversion Layer, Thermal Decomposition Layer, and Pressure-sensitive Adhesive Sheet

With regard to each of the pressure-sensitive adhesive sheets obtained in Examples and Comparative Examples, the light transmittances of the photothermal conversion layer, the thermal decomposition layer, and the pressure-sensitive adhesive sheet were measured. In the evaluation, the pressure-sensitive adhesive sheet, the photothermal conversion layer, and the thermal decomposition layer after UV light (specific wavelength: 365 nm, integrated light quantity: 1,380 mJ/cm²) of a high-pressure mercury lamp was applied once from one side to each of the pressure-sensitive adhesive sheets were each used as an evaluation sample.

The evaluation sample was set in a spectrophotometer (product name: "UV-VIS SPECTROPHOTOMETER SolidSpec 3700", manufactured by Shimadzu Corporation), and its light transmittance in the wavelength region of from 300 nm to 2,500 nm was measured while incident light was adapted to vertically enter each sample. Transmittances at wavelengths of 355 nm and 1,032 nm in the resultant transmission spectrum were extracted.

### (5) Pressure-sensitive Adhesive Strength on Pressure-sensitive Adhesive Layer Side

The thermal decomposition layer side of the pressure-sensitive adhesive sheet was bonded and fixed to a stainless-steel plate, and the pressure-sensitive adhesive layer was bonded to a polyethylene terephthalate film (manufactured by Toray Industries, Inc., product name: "Lumirror S10", thickness: 25 µm). A pressure-sensitive adhesive strength to PET #25 on the pressure-sensitive adhesive layer side was measured by a method in conformity with JIS Z 0237:2000 (bonding conditions: one reciprocation of a 2-kilogram roller, tensile rate: 300 mm/min, peel angle: 180°, measurement temperature: 23°C).

### (6) Initial Pressure-sensitive Adhesive Strength to Glass (Thermal Decomposition Layer Side)

The thermal decomposition layer side of the pressure-sensitive adhesive sheet was bonded to glass, and an initial pressure-sensitive adhesive strength to glass of the pressure-sensitive adhesive sheet on the thermal decomposition layer side was measured by a method in conformity with JIS Z 0237:2000 (bonding conditions: one reciprocation of a 2-kilogram roller, tensile rate: 300 mm/min, peel angle: 180°, measurement temperature: 23°C). A non-tin surface of a glass slide (manufactured by Matsunami Glass Ind., Ltd., product number: S200423 (Water Edge Grinding, 65 mm×165 mm×1.3 mmT)) was used as the above-mentioned glass and glass in the following evaluation (7). The non-tin surface was recognized as a surface in which coloring was not exhibited through the UV irradiation with a UV lamp.

### (7) Pressure-sensitive Adhesive Strength to Glass after UV irradiation (Thermal Decomposition Layer Side)

The thermal decomposition layer side of the pressure-sensitive adhesive sheet was bonded to glass, and UV light (specific wavelength: 365 nm, integrated light quantity: 1,380 mJ/cm²) of a high-pressure mercury lamp was applied from the glass side to the entire surface of the thermal decomposition layer through use of a UV irradiation apparatus (manufactured by Nitto Seiki Co., Ltd., product name: "UM-810"). After that, a pressure-sensitive adhesive strength to glass after UV irradiation was measured by a method in conformity with JIS Z 0237:2000 (bonding conditions: one reciprocation of a 2-kilogram roller, tensile rate: 300 mm/min, peel angle: 180°, measurement temperature: 23°C).

### (8) Laser Debonding Property Evaluation

The pressure-sensitive adhesive layer side of each of the pressure-sensitive adhesive sheets obtained in Examples and Comparative Examples was bonded to thin glass (cover glass manufactured by Matsunami Glass Ind., Ltd., Rectangular No. 1, product name: "C050701") having a width of 50 mm, a length of 70 mm, and a thickness of 0.12 mmt, the thin glass simulating a workpiece such as a semiconductor wafer, with a hand roller, and the pressure-sensitive adhesive sheet was cut in accordance with the size of the thin glass. After that, the thermal decomposition layer side thereof was laminated on a support (thick glass (large glass slide manufactured by Matsunami Glass Ind., Ltd., Standard Large White Edge Grinding No. 2, product name: "S9112") having a width of 52 mm, a length of 76 mm, and a thickness of 1.0 mmt, the thick glass simulating an optically transparent support substrate) with a hand roller. After that, the laminate was loaded in an autoclave, and was defoamed by warming (at 40°C and 5 kgf for 10 minutes) so that air bubbles trapped in the laminate were removed. Further, UV light (specific wavelength: 365 nm, integrated light quantity: 1,380 mJ/cm²) of a high-pressure mercury lamp was applied from the thick glass side to the entire surface of the thermal decomposition layer through use of a UV irradiation apparatus (manufactured by Nitto Seiki Co., Ltd., product name: "UM-810"). Thus, a laminate sample was produced.

Laser light was applied from the support side to the produced laminate sample to perform a laser debonding property evaluation. Specifically, in the case of an IR laser debonding evaluation, a pulse scan was performed with laser light having a wavelength of 1,032 nm and a beam diameter of about 80 µmϕ at an output of 7.7 W and a frequency of 25 kHz so that pitch intervals were about 80 um longitudinally and laterally. Alternatively, in the case of a UV laser debonding evaluation, a pulse scan was performed with line laser light having a wavelength of 355 nm, a beam width of about 10 um, a beam length of about 1.5 mm, and an energy density of 0.5 J/cm² at an output of 0.75 W and a frequency of 10 kHz so that overlapping of intervals of the centers of lines occurred for about 10 um in a width direction and about 0.2 mm or more in a length direction. After the application of the respective kinds of laser light having the corresponding wavelengths to the laminate sample, whether or not debonding was able to be performed for the thin glass (workpiece) and the support was recognized, and a site to be debonded was identified. Which laser light was used is shown in Table 1.

The evaluation of laser debonding workability was performed as described below. In the debonding work of the thin glass and the thick glass, the level at which the debonding was able to be easily performed when one site of the outer peripheral portion of the laminate sample was lifted with a cutter blade was evaluated as the debonding workability of "o", the level at which the debonding was able to be performed only when the entire outer peripheral portion was lifted with a cutter blade was evaluated as "Δ", and the level at which the debonding was unable to be performed even when a cutter blade was inserted in the outer peripheral portion or cracking of the thin glass (workpiece) occurred was evaluated as "×".

### (9) Thermal Decomposition Layer Residue Removing Workability Evaluation

For a sample in which debonding of the thin glass and the thick glass was achieved in the (8) laser debonding property evaluation, a removing workability evaluation on the residue of the thermal decomposition layer remaining on the thick glass was performed. Specifically, a polyester tape "NO. 315" manufactured by Nitto Denko Corporation was used as a support tape for removing a residue, and the tape was bonded to the thermal decomposition layer remaining as a residue with a hand roller. After that, the thermal decomposition layer residue removing workability was evaluated by whether pickup was able to be satisfactorily performed when peeling of the thermal decomposition layer was attempted by pulling the tape.

With regard to a bonding property of the tape "NO. 315", the level at which a small amount of soot occurred on the surface of the thermal decomposition layer and NO. 315 was satisfactorily bonded thereto was evaluated as "o", and the level at which a large amount of soot occurred thereon and NO. 315 was not bonded thereto was evaluated as "×".

In addition, with regard to a pickup property of the thermal decomposition layer remaining as a residue, the ease of tearing of a film-shaped thermal decomposition layer when NO. 315 was pulled was observed, and a case in which the thermal decomposition layer was not teared at the time of the peeling was evaluated as "o", and a case in which the thermal decomposition layer was teared was evaluated as "×".

### (10) Recoverability Evaluation of Support

A recoverability evaluation of the support was performed for a sample in which debonding of the thin glass and the thick glass was achieved in the (8) laser debonding property evaluation. Specifically, the state of contamination on the support after the laser debonding was visually observed, and a case in which a residue that was unable to be removed by peeling and was visible did not remain was evaluated as "o", and a case in which the residue remained was evaluated as "×".

### (11) Strain at Break at 25°C of Thermal Decomposition Layer after UV irradiation

UV light (specific wavelength: 365 nm, integrated light quantity: 1,380 mJ/cm²) of a high-pressure mercury lamp was applied once from one side to each of the thermal decomposition layers obtained in Examples and Comparative Examples. Thus, an evaluation sample was obtained. After that, the strain at break at 25°C of the thermal decomposition layer after UV irradiation was measured by a tensile test based on JIS K 7161:1994 and JIS K 7127:1999. The strain at break (%) is determined by (length (mm) of breaking point-length (mm) of initial test piece)/length (mm) of initial test piece×100.

### [Production Example 1] Production of Acrylic Polymer A

50 Parts by weight of butyl acrylate, 50 parts by weight of ethyl acrylate, 5 parts by weight of acrylic acid, 0.1 part by weight of 2-hydroxyethyl acrylate, 0.3 part by weight of trimethylolpropane triacrylate, and 0.1 part by weight of benzoyl peroxide serving as a polymerization initiator were added into toluene, and then the mixture was heated to 70°C to provide a solution of an acrylic polymer (polymer A) in toluene.

### [Production Example 2] Production of Acrylic Polymer B

95 Parts by weight of 2-ethylhexyl acrylate, 5 parts by weight of acrylic acid, and 0.15 part by weight of benzoyl peroxide serving as a polymerization initiator were added into ethyl acetate, and then the mixture was heated to 70°C to provide a solution of an acrylic polymer (polymer B) in ethyl acetate.

### [Production Example 3] Production of Acrylic Polymer C

30 Parts by weight of 2-ethylhexyl acrylate, 70 parts by weight of methyl acrylate, 10 parts by weight of acrylic acid, and 0.2 part by weight of benzoyl peroxide serving as a polymerization initiator were added into ethyl acetate, and then the mixture was heated to 70°C to provide a solution of an acrylic polymer (polymer C) in ethyl acetate.

### [Production Example 4] Production of Acrylic Polymer D

88.8 Parts by weight of 2-ethylhexyl acrylate, 11.2 parts by weight of 2-hydroxyethyl acrylate, 0.2 part by weight of a polymerization initiator (manufactured by Nippon Oil & Fats Co., Ltd., product name: "NYPER BW"), and toluene were mixed. The resultant mixture was polymerized under a stream of nitrogen gas at 60°C to provide an acrylic copolymer having a weight average molecular weight (Mw) of about 600,000.

12 Parts by weight of methacryloyloxyethyl isocyanate (MOI) and 0.06 part by weight of butyltin dilaurate were added to the toluene solution containing 100 parts by weight of the acrylic copolymer, and MOI was subjected to an addition reaction. Thus, an acrylic polymer D having a carbon-carbon double bond was prepared.

### [Production Example 5] Preparation of Pressure-sensitive Adhesive having Pressure Sensitivity

The solution of the polymer B in ethyl acetate (polymer B: 100 parts by weight) and 2 parts by weight of an epoxy-based cross-linking agent (manufactured by Mitsubishi Gas Chemical Company, Inc., product name: "TETRAD-C") were mixed to prepare a pressure-sensitive adhesive. The composition of the pressure-sensitive adhesive is shown in Table 1.

### [Production Example 6] Preparation of Composition I for forming Thermal Decomposition Layer (Pressure-sensitive Adhesive I)

The solution of the polymer A in toluene (polymer A: 100 parts by weight), 1 part by weight of an epoxy-based cross-linking agent (manufactured by Mitsubishi Gas Chemical Company, Inc., product name: "TETRAD-C"), 20 parts by weight of a UV oligomer (manufactured by Mitsubishi Chemical Corporation, product name: "SHIKOH UV-1700B"), 50 parts by weight of a UV oligomer (manufactured by Mitsubishi Chemical Corporation, product name: "SHIKOH UV-3000B"), and 0.5 part by weight of a photopolymerization initiator (manufactured by BASF SE, product name: "Omnirad 127D") were mixed to prepare a composition I for forming a thermal decomposition layer.

### [Production Example 7] Preparation of Composition II for forming Thermal Decomposition Layer (Pressure-sensitive Adhesive II)

A composition II for forming a thermal decomposition layer was prepared in the same manner as in Production Example 6 except that the blending amount of the UV oligomer (manufactured by Mitsubishi Chemical Corporation, product name: "SHIKOH UV-1700B") was changed to 50 parts by weight.

### [Production Example 8] Preparation of Composition III for forming Thermal Decomposition Layer (Pressure-sensitive Adhesive III)

A composition III for forming a thermal decomposition layer was prepared in the same manner as in Production Example 6 except that: the blending amount of the UV oligomer (manufactured by Mitsubishi Chemical Corporation, product name: "SHIKOH UV-1700B") was changed to 70 parts by weight; and the blending amount of the UV oligomer (manufactured by Mitsubishi Chemical Corporation, product name: "SHIKOH UV-3000B") was changed to 30 parts by weight.

### [Production Example 9] Preparation of Composition IV for forming Thermal Decomposition Layer (Pressure-sensitive Adhesive IV)

The solution of the polymer A in toluene (polymer A: 100 parts by weight), 1 part by weight of an epoxy-based cross-linking agent (manufactured by Mitsubishi Gas Chemical Company, Inc., product name: "TETRAD-C"), 100 parts by weight of a UV oligomer (manufactured by Mitsubishi Chemical Corporation, product name: "SHIKOH UV-1700B"), and 0.5 part by weight of a photopolymerization initiator (manufactured by BASF SE, product name: "Omnirad 127D") were mixed to prepare a composition IV for forming a thermal decomposition layer.

### [Production Example 10] Preparation of Composition V for forming Thermal Decomposition Layer (Pressure-sensitive Adhesive V)

The solution of the polymer C in ethyl acetate (polymer C: 100 parts by weight), 0.1 part by weight of an epoxy-based cross-linking agent (manufactured by Mitsubishi Gas Chemical Company, Inc., product name: "TETRAD-C"), 40 parts by weight of an active energy ray-reactive compound (UV-curable oligomer, manufactured by DIC Corporation, product name: "LUXYDIR V-6841"), and 0.5 part by weight of a photopolymerization initiator (manufactured by BASF SE, product name: "Omnirad 127D") were mixed to prepare a composition V for forming a thermal decomposition layer.

### [Production Example 11] Preparation of Composition VI for forming Thermal Decomposition Layer (Pressure-sensitive Adhesive VI)

A composition VI for forming a thermal decomposition layer was prepared in the same manner as in Production Example 9 except that the blending amount of the active energy ray-reactive compound (manufactured by DIC Corporation, product name: " LUXYDIR V-6841") was changed to 250 parts by weight.

### [Production Example 12] Composition I for forming Photothermal Conversion Layer

The solution of the polymer A in toluene (polymer A: 100 parts by weight), 1 part by weight of an epoxy-based cross-linking agent (manufactured by Mitsubishi Gas Chemical Company, Inc., product name: "TETRAD-C"), 70 parts by weight of a UV oligomer (manufactured by Mitsubishi Chemical Corporation, product name: "SHIKOH UV-1700B"), 30 parts by weight of a UV oligomer (manufactured by Mitsubishi Chemical Corporation, product name: "SHIKOH UV-3000B"), 0.5 part by weight of a photopolymerization initiator (manufactured by BASF SE, product name: "Omnirad 127D"), and 20 parts by weight of a UV absorber (reaction product of 2-(4,6-bis(2,4-dimethylphenyl)-1,3,5-triazin-2-yl)-5-hydroxyphenyl and a [(C10-C16 (mainly C12-C13) alkyloxy)methyl]oxirane, product name: "TINUVIN 400", manufactured by BASF SE) were mixed to prepare a composition I for forming a photothermal conversion layer.

### [Example 1]

The pressure-sensitive adhesive having pressure sensitivity obtained in Production Example 5 was applied to one side of a polyimide film (manufactured by Du Pont-Toray Co., Ltd., product name: "Kapton 100H", thickness: 25 um) serving as a photothermal conversion layer so as to have a thickness of 10 um after solvent volatilization (drying), and was then dried to form a pressure-sensitive adhesive layer having pressure sensitivity on the polyimide film. The resultant was bonded to a polyethylene terephthalate film with a silicone release agent-treated surface (manufactured by Toray Industries, Inc., product name: "Cerapeel", thickness: 38 um) through lamination between rolls.

Next, the composition I for forming a thermal decomposition layer obtained in Production Example 6 was applied to a polyethylene terephthalate film with a silicone release agent-treated surface (thickness: 75 um) so as to have a thickness of 50 um after solvent volatilization (drying), and was then dried. The resultant was bonded to the above-mentioned polyimide film on the opposite side to the pressure-sensitive adhesive layer having pressure sensitivity through lamination between rolls.

Thus, a pressure-sensitive adhesive sheet (pressure-sensitive adhesive layer (pressure-sensitive adhesive layer having pressure sensitivity)/photothermal conversion layer (polyimide film)/thermal decomposition layer) sandwiched between the polyethylene terephthalate films with silicone release agent-treated surfaces was obtained.

The resultant pressure-sensitive adhesive sheet was subjected to the above-mentioned evaluations. The results are shown in Table 1.

### [Example 2 to Example 9]

Pressure-sensitive adhesive sheets were each obtained in the same manner as in Example 1 except that: a resin film (photothermal conversion layer) and a composition for forming a thermal decomposition layer shown in Table 1 were used; and the thicknesses of the respective layers were changed as shown in Table 1. The resultant pressure-sensitive adhesive sheets were subjected to the above-mentioned evaluations. The results are shown in Table 1.

A resin film "black compounded polyimide" used as the photothermal conversion layer is a black compounded polyimide film (manufactured by Du Pont-Toray Co., Ltd., product name: "Kapton 50MCB", thickness: 12.5 um). In addition, a black printed PET (1) is a polyethylene terephthalate film with a printed layer, and is a resin film having a transmittance for light having a wavelength of 1,032 nm of 43.66%. In addition, a black printed PET (2) is a polyethylene terephthalate film with a printed layer, and is a resin film having a transmittance for light having a wavelength of 1,032 nm of 0%.

### [Example 10]

The pressure-sensitive adhesive having pressure sensitivity obtained in Production Example 5 was applied to a polyethylene terephthalate film with a silicone release agent-treated surface (thickness: 75 um) so as to have a thickness of 10 um after solvent volatilization (drying), and was then dried to form a pressure-sensitive adhesive layer on the polyethylene terephthalate film.

The composition I for forming a photothermal conversion layer obtained in Production Example 12 was applied to a polyethylene terephthalate film with a silicone release agent-treated surface (manufactured by Toray Industries, Inc., product name: "Cerapeel", thickness: 38 um) so as to have a thickness of 30 um after solvent volatilization (drying), and was then dried to form a photothermal conversion precursor layer on the polyethylene terephthalate film.

Next, the pressure-sensitive adhesive layer and the photothermal conversion precursor layer were bonded to each other through lamination between rolls, and the resultant was subjected to UV irradiation from the photothermal conversion precursor layer side under the condition of 500 mJ/cm². Thus, a laminate (pressure-sensitive adhesive layer/photothermal conversion layer) sandwiched between the polyethylene terephthalate films with silicone release agent-treated surfaces was obtained.

The composition III for forming a thermal decomposition layer obtained in Production Example 8 was applied to a polyethylene terephthalate film with a silicone release agent-treated surface (manufactured by Toray Industries, Inc., product name: "Cerapeel", thickness: 38 um) so as to have a thickness of 50 um after solvent volatilization (drying), and was then dried to form a thermal decomposition layer on the polyethylene terephthalate film.

After the polyethylene terephthalate film with a silicone release agent-treated surface on the photothermal conversion layer side of the laminate was peeled, the photothermal conversion layer and the thermal decomposition layer were bonded to each other through lamination between rolls. Thus, a pressure-sensitive adhesive sheet (pressure-sensitive adhesive layer (pressure-sensitive adhesive layer having pressure sensitivity)/photothermal conversion layer/thermal decomposition layer) sandwiched between the polyethylene terephthalate films with silicone release agent-treated surfaces was obtained.

The resultant pressure-sensitive adhesive sheet was subjected to the above-mentioned evaluations. The results are shown in Table 1.

### [Comparative Example 1]

The pressure-sensitive adhesive having pressure sensitivity obtained in Production Example 5 was applied to one side of a polyethylene terephthalate film (manufactured by Toray Industries, Inc., product name: "Lumirror S10", thickness: 25 um) so as to have a thickness of 10 um after solvent volatilization (drying), and was then dried to form a pressure-sensitive adhesive layer on the polyethylene terephthalate film. The resultant was bonded to a polyethylene terephthalate film with a silicone release agent-treated surface (manufactured by Toray Industries, Inc., product name: "Cerapeel", thickness: 38 um) through lamination between rolls.

Next, the composition I for forming a photothermal conversion layer obtained in Production Example 12 was applied to a polyethylene terephthalate film with a silicone release agent-treated surface (thickness: 75 um) so as to have a thickness of 50 um after solvent volatilization (drying), and was then dried. The resultant was bonded to the above-mentioned polyethylene terephthalate film on the opposite side to the pressure-sensitive adhesive layer through lamination between rolls, and was subjected to UV irradiation under the condition of 1,380 mJ/cm².

Thus, a pressure-sensitive adhesive sheet (pressure-sensitive adhesive layer (pressure-sensitive adhesive layer having pressure sensitivity)/base material layer/photothermal conversion layer) sandwiched between the polyethylene terephthalate films with silicone release agent-treated surfaces was obtained. The pressure-sensitive adhesive sheet of this Experimental Example is a pressure-sensitive adhesive sheet free of a thermal decomposition layer, and exhibits peelability through decomposition of the photothermal conversion layer by laser light irradiation. In other words, the photothermal conversion layer also has a function of the thermal decomposition layer.

The resultant pressure-sensitive adhesive sheet was subjected to the above-mentioned evaluations. The results are shown in Table 1.

### [Comparative Example 2]

### (Preparation of Composition II for forming Photothermal Conversion Layer)

The solution of the acrylic polymer D in toluene obtained in Production Example 4 (polymer D: 100 parts by weight), 0.2 part by weight of an isocyanate-based cross-linking agent (manufactured by Tosoh Corporation, product name: "CORONATE L"), 3 parts by weight of a photopolymerization initiator (manufactured by BASF SE, product name: "Omnirad 127D"), and 12.5 parts by weight of a UV absorber (product name: "TINUVIN 400", manufactured by BASF SE) were mixed to prepare a composition II for forming a photothermal conversion layer.

### (Production of Pressure-sensitive Adhesive Sheet)

The pressure-sensitive adhesive having pressure sensitivity obtained in Production Example 5 was applied to one side of a polyethylene terephthalate film (manufactured by Toray Industries, Inc., product name: "Lumirror S10", thickness: 25 um) so as to have a thickness of 10 um after solvent volatilization (drying), and was then dried to form a pressure-sensitive adhesive layer on the polyethylene terephthalate film. The resultant was bonded to a polyethylene terephthalate film with a silicone release agent-treated surface (manufactured by Toray Industries, Inc., product name: "Cerapeel", thickness: 38 um) through lamination between rolls.

Next, the composition II for forming a photothermal conversion layer was applied to a polyethylene terephthalate film with a silicone release agent-treated surface (thickness: 75 um) so as to have a thickness of 50 um after solvent volatilization (drying), and was then dried. The resultant was bonded to the above-mentioned polyethylene terephthalate film on the opposite side to the pressure-sensitive adhesive layer through lamination between rolls.

Thus, a pressure-sensitive adhesive sheet (pressure-sensitive adhesive layer (pressure-sensitive adhesive layer having pressure sensitivity)/base material layer/photothermal conversion layer) sandwiched between the polyethylene terephthalate films with silicone release agent-treated surfaces was obtained. The pressure-sensitive adhesive sheet of this Experimental Example is a pressure-sensitive adhesive sheet free of a thermal decomposition layer, and exhibits peelability through decomposition of the photothermal conversion layer by laser light irradiation. In other words, the photothermal conversion layer also has a function of the thermal decomposition layer.

The resultant pressure-sensitive adhesive sheet was subjected to the above-mentioned evaluations. The results are shown in Table 1.

### [Comparative Example 3]

The pressure-sensitive adhesive having pressure sensitivity obtained in Production Example 5 was applied to a polyethylene terephthalate film with a silicone release agent-treated surface (thickness: 75 um) so as to have a thickness of 10 um after solvent volatilization (drying), and was then dried to form a pressure-sensitive adhesive layer on the polyethylene terephthalate film.

The composition II for forming a photothermal conversion layer obtained in Comparative Example 2 was applied to a polyethylene terephthalate film with a silicone release agent-treated surface (manufactured by Toray Industries, Inc., product name: "Cerapeel", thickness: 38 um) so as to have a thickness of 30 um after solvent volatilization (drying), and was then dried to form a photothermal conversion precursor layer on the polyethylene terephthalate film.

Next, the pressure-sensitive adhesive layer and the photothermal conversion precursor layer were bonded to each other through lamination between rolls, and the resultant was subjected to UV irradiation from the photothermal conversion precursor layer side under the condition of 500 mJ/cm². Thus, a laminate (pressure-sensitive adhesive layer/photothermal conversion layer) sandwiched between the polyethylene terephthalate films with silicone release agent-treated surfaces was obtained.

The composition III for forming a thermal decomposition layer obtained in Production Example 8 was applied to a polyethylene terephthalate film with a silicone release agent-treated surface (manufactured by Toray Industries, Inc., product name: "Cerapeel", thickness: 38 um) so as to have a thickness of 50 um after solvent volatilization (drying), and was then dried to form a thermal decomposition layer on the polyethylene terephthalate film.

After the polyethylene terephthalate film with a silicone release agent-treated surface on the photothermal conversion layer side of the laminate was peeled, the photothermal conversion layer and the thermal decomposition layer were bonded to each other through lamination between rolls. Thus, a pressure-sensitive adhesive sheet (pressure-sensitive adhesive layer (pressure-sensitive adhesive layer having pressure sensitivity)/photothermal conversion layer/thermal decomposition layer) sandwiched between the polyethylene terephthalate films with silicone release agent-treated surfaces was obtained.

The resultant pressure-sensitive adhesive sheet was subjected to the above-mentioned evaluations. The results are shown in Table 1.

**Table 1**

| | | Example 1 | Example 2 | Example 3 | Example 4 | Example 5 |
|---|---|---|---|---|---|---|
| Phot othe rmal conv ersi on laye r | Material | PI (polyim ide) | PI (polyim ide) | PI (polyim ide) | PI (polyim ide) | PI (polyim ide) |
| | Thickness [µm] | 25 | 25 | 25 | 25 | 25 |
| | Tensile modulus of elasticity at 200°C after UV irradiation [MPa] | 1,585 | 1,585 | 1,585 | 1,585 | 1,585 |
| | 5% weight loss temperature after UV irradiation [°C] | 589.1 | 589.1 | 589.1 | 589.1 | 589.1 |
| | Transmittance for light having wavelength of 355 nm after UV irradiation [%] | 0.00 | 0.00 | 0.00 | 0.00 | 0.00 |
| | Transmittance for light having wavelength of 1,032 nm after UV irradiation [%] | 87.39 | 87.39 | 87.39 | 87.39 | 87.39 |
| Ther mal deco mpos itio n laye r | Number of composition for forming thermal decomposition layer | I | II | III | IV | V |
| | Thickness [µm] | 50 | 50 | 50 | 50 | 30 |
| | Tensile modulus of elasticity at 25°C after UV irradiation [MPa] | 16 | 174 | 324 | 457 | 50 |
| | Strain at break after UV irradiation [%] | 152.0 | 123.6 | 79.1 | 4.2 | 52.3 |
| | 5% weight loss temperature after UV irradiation [°C] | 341.1 | 343.6 | 346.4 | 349.1 | 344.9 |
| | Transmittance for light having wavelength of 355 nm after UV irradiation [%] | 90.27 | 90.23 | 90.29 | 90.15 | 89.90 |
| | Transmittance for light having wavelength of 1,032 nm after UV irradiation [%] | 94.06 | 94.01 | 94.10 | 94.02 | 94.50 |

| | | | | | | | |
|---|---|---|---|---|---|---|---|
| Pres sure-sens itiv e adhe sive shee t | Difference between thermal decomposition temperatures {T(LTHC)-T(TD)} [°C] | | 248.0 | 245.5 | 242.7 | 240.0 | 244.2 |
| | Pressur e-sensiti ve adhesiv e charact eristic on pressur e-sensiti ve adhesiv e layer side | Pressu resensit ive adhesi ve streng th on pressu resensit ive adhesi ve layer side [N/20 mm] | 0.82 | 0.82 | 0.82 | 0.82 | 0.82 |
| | Pressur e-sensiti ve adhesiv e charact eristic s on thermal decompo sition layer side | Initia l pressu resensit ive adhesi ve streng th to glass [N/20 mm] | 3.12 | 4.53 | 6.40 | 5.61 | 13.60 |
| | | Pressu resensit ive adhesi ve streng th to glass after UV irradi ation [N/20 mm] | 1.24 | 0.62 | 0.37 | 0.04 | 0.67 |
| | Optical charact eristic s | Transm ittanc e for light having wavele ngth of 355 nm after UV irradi ation [%] | 0.00 | 0.00 | 0.00 | 0.00 | 0.00 |
| | | Transmittanc e for light having wavele ngth of 1,032 nm after UV irradi ation [%] | 87.12 | 87.23 | 87.01 | 88.20 | 88.67 |
| | Laser debondi ng propert y | Laser light applie d | UV (355 nm) | UV (355 nm) | UV (355 nm) | UV (355 nm) | UV (355 nm) |
| | | Debond ing workab ility | ○ | ○ | ○ | ○ | ○ |
| | Thermal decompo sition layer residue removin g workabi lity | Pickup proper ty with NO. 315 | ○ | ○ | ○ | ○ | ○ |
| | | Ease of tearin g of sheet at time of remova l work | ○ | ○ | ○ | × | ○ |
| | Recover ability of support | Contam inatio n after laser debond ing | ○ | ○ | ○ | ○ | ○ |

| | | Example 6 | Example 7 | Example 8 | Example 9 | Example 10 | Comparative Example 3 |
|---|---|---|---|---|---|---|---|
| Phot othe rmal conv ersi on laye r | Material | PI (polyim ide) | Black compoun ded PI | Black printed PET (1) | Black printed PET (2) | Acrylic (compos ition I for forming phototh ermal convers ion layer) | Cured/acryl ic (compositio n II for forming phototherma l conversion layer) |
| | Thickness [µm] | 25 | 12.5 | 25 | 25 | 30 | 30 |
| | Tensile modulus of elasticity at 200°C after UV irradiation [MPa] | 1,585 | 1, 413 | 269 | 269 | 10 | 1.26 |
| | Transmittance for light having wavelength of 355 nm after UV irradiation [%] | 0.00 | 0.00 | 0.69 | 0.00 | 0.00 | 0.00 |
| | Transmittance for light having wavelength of 1,032 nm after UV irradiation [%] | 87.39 | 1.57 | 43.66 | 0.00 | 93.10 | 92.00 |
| | Number of composition for forming thermal decomposition layer | VI | I | I | I | III | III |
| | Thickness [µm] | 30 | 50 | 50 | 50 | 50 | 50 |
| | Tensile modulus of elasticity at 25°C after UV irradiation [MPa] | 759 | 16 | 16 | 16 | 324 | 324 |
| | Strain at break after UV irradiation [%] | 10.7 | 152.0 | 152.0 | 152.0 | 79.1 | 79.1 |
| | 5% weight loss temperature after UV irradiation [°C] | 350.1 | 341.1 | 341.1 | 341.1 | 346.4 | 346.4 |
| | Transmittance for light having wavelength of 355 nm after UV irradiation [%] | 90.10 | 90.27 | 90.27 | 90.27 | 90.29 | 90.29 |
| | Transmittance for light having wavelength of 1,032 nm after UV irradiation [%] | 94.60 | 94.06 | 94.06 | 94.06 | 94.10 | 94.10 |

| | | | | | | | | |
|---|---|---|---|---|---|---|---|---|
| Pres sure -sens itiv e adhe sive shee t | Difference between thermal decomposition temperatures {T(LTHC)-T(TD)} [°C] | | 239.0 | 245.7 | 52.3 | 15.8 | 29.3 | -57.2 |
| | Pressur e-sensiti ve adhesiv e charact eristic on pressur e-sensiti ve adhesiv e layer side | Pressu resensit ive adhesi ve streng th on pressu resensit ive adhesi ve layer side [N/20 mm] | 0.82 | 0.82 | 0.82 | 0.82 | 0.82 | 0.82 |
| | Pressur e-sensiti ve adhesiv e charact eristic s on thermal decompo sition layer side | Initia l pressu resensit ive adhesi ve streng th to glass [N/20 mm] | 14.20 | 3.23 | 3.51 | 3.30 | 6.12 | 4.10 |
| | | Pressu resensit ive adhesi ve streng th to glass after UV irradi ation [N/20 mm] | 0.02 | 0.96 | 1.12 | 1.06 | 0.43 | 2.26 |
| | Optical charact eristic s | Transm ittanc e for light having wavele ngth of 355 nm after UV irradi ation [%] | 0.00 | 0.00 | 0.62 | 0.00 | 0.00 | 0.00 |
| | | Transm ittanc e for light having wavele ngth of 1,032 nm after UV irradi ation [%] | 88.31 | 1.43 | 42.15 | 0.00 | 89.57 | 90.20 |
| | Laser debondi ng propert y | Laser light applie d | UV (355 nm) | IR (1,032 nm) | IR (1,032 nm) | IR (1,032 nm) | UV (355 nm) | UV (355 nm) |
| | | Debond ing workab ility | ○ | ○ | ○ | ○ | Δ | × |
| | Thermal decompo sition layer residue removin g workabi lity | Pickup proper ty with NO. 315 | ○ | ○ | ○ | ○ | ○ | - |
| | | Ease of tearin g of sheet at time of remova l work | × | ○ | ○ | ○ | ○ | - |
| | Recover ability of support | Contam inatio n after laser debond ing | ○ | ○ | ○ | ○ | ○ | - |

| | | | Compara tive Example 1 | Compara tive Example 2 |
|---|---|---|---|---|
| Phot othe rmal conv ersi on laye r | Number of composition for forming thermal decomposition layer | | I | II |
| | Thickness [µm] | | 50 | 30 |
| | Tensile modulus of elasticity at 25°C [MPa] | | 16 | 1.26 |
| | 5% weight loss temperature after UV irradiation [°C] | | 375.7 | 289.2 |
| | Transmittance for light having wavelength of 355 nm after UV irradiation [%] | | 0.00 | 0.00 |
| | Transmittance for light having wavelength of 1,032 nm after UV irradiation [%] | | 93.10 | 92.00 |
| Pres sure -sens itiv e adhe sive shee t | Pressur e-sensiti ve adhesiv e charact eristic on pressur e-sensiti ve adhesiv e layer side | Pressu resensit ive adhesi ve streng th on pressu resensit ive adhesi ve layer side [N/20 mm] | 0.82 | 0.82 |
| | Pressur e-sensiti ve adhesiv e charact eristic s on thermal decompo sition layer side | Initia l pressu resensit ive adhesi ve streng th to glass [N/20 mm] | 6.92 | 3.24 |
| | | Pressu resensit ive adhesi ve streng th to glass after UV irradi ation [N/20 mm] | 0.6 | 0.07 |
| | Optical charact eristic s | Transm ittanc e for light having wavele ngth of 355 nm after UV irradi ation [%] | 0.00 | 0.00 |
| | | Transm ittanc e for light having wavele ngth of 1,032 nm after UV irradi ation [%] | 89.80 | 89.91 |
| | Laser debondi ng propert y | Laser light applie d | UV (355 nm) | UV (355 nm) |
| | | Debond ing workab ility | Δ | × |
| | Thermal decompo sition layer residue removin g workabi lity | Pickup proper ty with NO. 315 | - | - |
| | | Ease of tearin g of sheet at time of remova l work | - | - |
| | Recover ability of support | Contam inatio n after laser debond ing | × | × |

As is apparent from Table 1, the pressure-sensitive adhesive sheet for temporarily fixing an electronic part of the present invention can satisfactorily separate an electronic part that has been temporarily fixed thereto from a support, and can easily remove a thermal decomposition layer residue on the support. In all of Examples, separation of the electronic part was achieved in interfacial peeling between the thermal decomposition layer and the photothermal conversion layer, and probably as a result of the foregoing, such an excellent effect as described above was obtained. Meanwhile, in each of Comparative Examples, a cohesive failure of the photothermal conversion layer occurred, and hence the effect as in the present invention could not be observed.

### Reference Signs List

**10** photothermal conversion layer
**20** thermal decomposition layer
**30** pressure-sensitive adhesive layer
**100** pressure-sensitive adhesive sheet for temporarily fixing electronic part
**200** support
**300** electronic part

## Claims

1. A pressure-sensitive adhesive sheet for temporarily fixing an electronic part, comprising:
a photothermal conversion layer; and
a thermal decomposition layer directly arranged on the photothermal conversion layer,
wherein a 5% weight loss temperature of the thermal decomposition layer after UV irradiation is lower than a 5% weight loss temperature of the photothermal conversion layer after UV irradiation.

2. The pressure-sensitive adhesive sheet for temporarily fixing an electronic part according to claim 1, wherein the 5% weight loss temperature of the photothermal conversion layer after UV irradiation is from 300°C to 600°C.

3. The pressure-sensitive adhesive sheet for temporarily fixing an electronic part according to claim 1 or 2, wherein the 5% weight loss temperature of the thermal decomposition layer after UV irradiation is from 250°C to 400°C.

4. The pressure-sensitive adhesive sheet for temporarily fixing an electronic part according to any one of claims 1 to 3, wherein the photothermal conversion layer has a transmittance for light having a wavelength of 355 nm of 50% or less.

5. The pressure-sensitive adhesive sheet for temporarily fixing an electronic part according to any one of claims 1 to 4, wherein the photothermal conversion layer is a resin film including a polyimide-based resin.

6. The pressure-sensitive adhesive sheet for temporarily fixing an electronic part according to any one of claims 1 to 5, wherein the thermal decomposition layer has a transmittance for light having a wavelength of 355 nm of 80% or more.

7. The pressure-sensitive adhesive sheet for temporarily fixing an electronic part according to any one of claims 1 to 3, wherein the photothermal conversion layer has a transmittance for light having a wavelength of 1,032 nm of 50% or less.

8. The pressure-sensitive adhesive sheet for temporarily fixing an electronic part according to any one of claims 1 to 3 and 7, wherein the photothermal conversion layer is a colored film.

9. The pressure-sensitive adhesive sheet for temporarily fixing an electronic part according to any one of claims 1 to 3, 7, and 8, wherein the thermal decomposition layer has a transmittance for light having a wavelength of 1,032 nm of 80% or more.

10. The pressure-sensitive adhesive sheet for temporarily fixing an electronic part according to any one of claims 1 to 9, wherein the thermal decomposition layer contains an active energy ray-curable pressure-sensitive adhesive.

11. The pressure-sensitive adhesive sheet for temporarily fixing an electronic part according to any one of claims 1 to 10, wherein the thermal decomposition layer has a strain at break after UV irradiation of 50% or more.

12. The pressure-sensitive adhesive sheet for temporarily fixing an electronic part according to any one of claims 1 to 11, wherein the photothermal conversion layer has a tensile modulus of elasticity at 200°C after UV irradiation of from 5 MPa to 2 GPa.

13. The pressure-sensitive adhesive sheet for temporarily fixing an electronic part according to any one of claims 1 to 12, further comprising a pressure-sensitive adhesive layer,
wherein the pressure-sensitive adhesive layer, the photothermal conversion layer, and the thermal decomposition layer are laminated in the stated order.

14. A method of treating an electronic part, comprising subjecting an electronic part to predetermined treatment after arranging the electronic part on the pressure-sensitive adhesive sheet of any one of claims 1 to 13.

15. The method of treating an electronic part according to claim 14, wherein the treatment is grinding processing, dicing processing, die bonding, wire bonding, etching, vapor deposition, molding, rewiring formation, through-hole formation, or protection of a device surface.
